# EUROPEAN PATENT SPECIFICATION

(11) **EP 4 429 067 B1**
(45) Date of publication and mention of the grant of the patent: **11.11.2026**
(21) Application number: 23865707.6
(22) Date of filing: 24.07.2023
(51) Int. Cl.: H02J 7/00, G01R 31/3842, G01R 31/385, H01M 10/48, B60L 58/12, G01R 31/382, G01R 31/36, G01R 22/06

(54) **BATTERY MANAGEMENT SYSTEM, BATTERY PACK, ELECTRIC VEHICLE AND BATTERY CHARGING TIME PREDICTION METHOD**
BATTERIEVERWALTUNGSSYSTEM, BATTERIEPACK, ELEKTROFAHRZEUG UND BATTERIELADEZEITVORHERSAGEVERFAHREN
SYSTÈME DE GESTION DE BATTERIE, BLOC-BATTERIE, VÉHICULE ÉLECTRIQUE ET PROCÉDÉ DE PRÉDICTION DE TEMPS DE CHARGE DE BATTERIE

(30) Priority: 15.09.2022 KR 20220116578; 02.05.2023 KR 20230057146
(43) Date of publication of application: 11.09.2024
(73) Proprietor: LG Energy Solution, Ltd., Seoul 07335 (KR)
(72) Inventor: KIM, Jae-Gu, Daejeon 34122 (KR)
(74) Representative: Plasseraud IP
(86) International application number: PCT/KR2023/010664
(87) International publication number: WO 2024/058404

(56) References cited:
- EP-A1- 2 899 843
- EP-B1- 3 664 247
- WO-A1-2021/045387
- JP-A- 2009 159 765
- KR-A- 20210 043 351
- KR-A- 20220 021 277
- US-A1- 2019 363 547
- US-A1- 2020 373 779

## Description

### TECHNICAL FIELD

The present disclosure relates to a technology for estimating a remaining charging time of a battery.

The present application claims priority to Korean Patent Application No. 10-2022-0116578 filed on September 15, 2022 in the Republic of Korea and Korean Patent Application No. 10-2023-0057146 filed on May 2, 2023 in the Republic of Korea.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

When charging a battery with constant current, if the charge rate (may also be referred to as 'C-rate') of the charging current is low, a very long time is required to fully charge the battery. On the other hand, if the charge rate is too high, it causes the side effect that the battery deteriorates quickly. Therefore, during constant-current charging, it is necessary to gradually adjust the charging current according to the state of the battery. For reference, the charge rate (C-rate) is the value obtained by dividing the charging current by the maximum capacity of the battery, and 'C' is used as the unit.

A 'multi-stage constant-current charging protocol' may be mainly used to change various charge rates predetermined for constant-current charging in stages. A charging map can be created for each of a plurality of temperature sections, and each charging map is a table or function in which the relationship between the plurality of reference current values (charge rates) and the plurality of transition conditions associated with the specific temperature section is recorded. If the state of the battery satisfies a specific transition condition (e.g., SOC reaches 60%) while charging using any one of the plurality of reference current values recorded in the specific charging map, the charging current of the next charge rate may be supplied to the battery.

Relatedly, during battery charging, it is necessary to notify the user of how much time remains until the SOC of the battery reaches a target SOC (e.g., fully charged state).

Conventionally, the remaining charging time to the target SOC was predicted by assuming that the output power from the charger was large enough to allow the charging current of the charge rate according to the multi-stage constant-current charging protocol to flow through the battery.

However, the maximum output power of the charger may sometimes be less than the charging power required for constant-current charging of the battery, and in such cases, the battery is charged using the constant-power charging mode instead of the constant-current charging mode. There is a big difference in battery charging speed depending on whether the constant-current charging mode or the constant-power charging mode is implemented. Therefore, in charging conditions where the output power of the charger is insufficient, there is a problem that there is a large deviation between the predicted value of the remaining charging time and the charging time actually consumed.

Document EP 3 664 247 discloses a charging time computation method and control device wherein battery temperature, surrounding temperature, and voltage are measured to calculate the state of charge of a battery and determine an optimal first charge power and a second, temperature-limited charge power is then used to compute the total charge time based on battery conditions and a reference map.

### DISCLOSURE

### Technical Problem

The present disclosure is designed to solve the problems of the related art, and therefore the present disclosure is directed to providing a battery management system that can improve the prediction accuracy of the total remaining time until the SOC of the battery reaches the target SOC by repeating the process of predicting the time required for charging at each stage (SOC range) based on the comparison result of the charging power required for the corresponding stage and the maximum output power of a charger while charging the battery according to a multi-stage constant-current charging protocol; a battery pack including the battery management system; an electric vehicle including the battery pack; and a battery charging time prediction method that can be implemented in the battery management system.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management system according to an aspect of the present disclosure is defined in the appended claims.

A battery pack according to another aspect of the present disclosure is provided.

An electric vehicle according to still another aspect of the present disclosure is also provided.

A battery charging time prediction method according to still another aspect of the present disclosure is also provided.

### Advantageous Effects

According to at least one of the embodiments of the present disclosure, during battery charging according to the multi-stage constant-current charging protocol, the prediction accuracy of the total remaining time until the SOC of the battery reaches the target SOC can be improved by repeating the process of predicting the time required for charging at the corresponding stage, based on the result of comparing the charging power required at each stage (SOC range) and the maximum output power of the charger.

In addition, according to at least one of the embodiments of the present disclosure, the prediction accuracy of charging time for each stage can be improved by predicting the battery temperature change amount at each stage, and selecting a charging map used to predict the charging time at the subsequent stage using the predicted battery temperature change amount.

In addition, according to at least one of the embodiments of the present disclosure, by adjusting the end point of each stage according to the difference between the predicted temperature change amount value and the actual temperature change amount for the corresponding stage, the safety of the charging procedure that will be resumed in the future can be improved, and also battery life may be prolonged.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a drawing illustrating the configuration of an electric vehicle according to the present disclosure.
FIGS. 2 to 4 are diagrams referenced to explain an exemplary reference charging map used in a charging procedure using a multi-stage constant-current charging protocol.
FIG. 5 is a diagram referenced to explain the effect of the maximum output power of the charger on the charging procedure using the multi-stage constant-current charging protocol.
FIG. 6 is a flowchart exemplarily illustrating a battery charging time prediction method according to the first embodiment of the present disclosure.
FIG. 7 is a flowchart illustrating the subroutines of step S630 shown in FIG. 6.
FIG. 8 is a flowchart illustrating the subroutines of step S750 shown in FIG. 7.
FIG. 9 is a schematic diagram referenced to explain the first and second thermal models used to predict the temperature change amount for each SOC section according to the multi-stage constant-current charging protocol.
FIG. 10 is a flowchart exemplarily illustrating a battery charging time prediction method according to the second embodiment of the present disclosure.
FIG. 11 is a flowchart exemplarily illustrating a battery charging time prediction method according to the third embodiment of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise. Additionally, terms such as "... unit" described in the specification refer to a unit that processes at least one function or operation, and may be implemented as hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

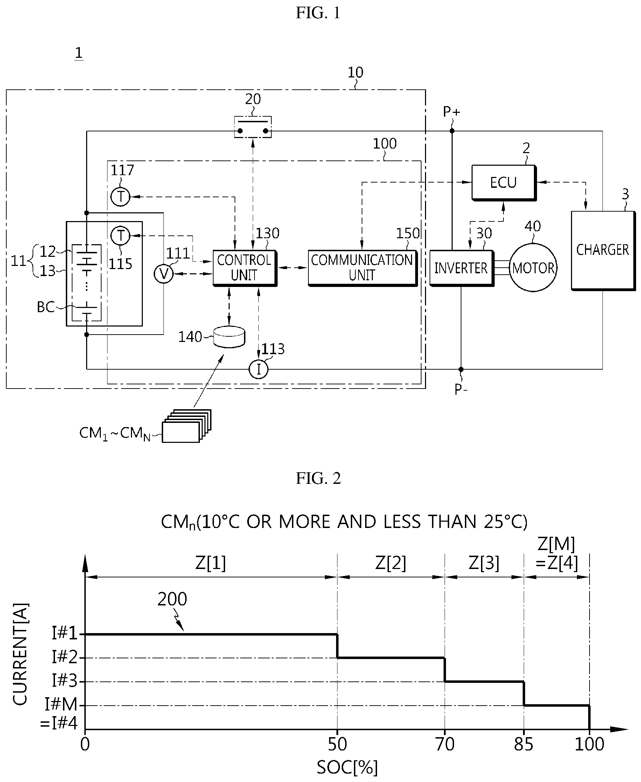

FIG. 1 is a drawing illustrating the configuration of an electric vehicle according to the present disclosure.

Referring to FIG. 1, the electric vehicle 1 includes a vehicle controller 2, a battery pack 10, a relay 20, an inverter 30, and an electric motor 40. The charging and discharging terminals P+, P- of the battery pack 10 can be electrically connected to the charger 3 through a charging cable, etc. The charger 3 may be included in the electric vehicle 1 or may be provided at the charging station.

The vehicle controller 2 (e.g., ECU: Electronic Control Unit) is configured to transmit a key-on signal to the battery management system 100 in response to the start button (not shown) provided in the electric vehicle 1 being switched to the ON position by the user. The vehicle controller 2 is configured to transmit a key-off signal to the battery management system 100 in response to the start button being switched to the OFF position by the user. The charger 3 can communicate with the vehicle controller 2 and supply constant-current or constant-voltage charging power through the charging and discharging terminals P+, P- of the battery pack 10.

The battery pack 10 includes a battery 11 and a battery management system 100.

The battery 11 includes a cell group 12 and a case 13. The case 13 defines the overall appearance of the battery 11 and provides an inner space where the cell group 12 can be placed. The case 13 is fixed to the battery room provided in the electric vehicle 1 using bolts, etc.

The cell group 12 is disposed (stored) in the inner space provided from the case 13 and includes at least one battery cell BC. The type of battery cell BC is not particularly limited as long as it can be repeatedly charged and discharged, for example, a lithium-ion cell.

When the cell group 12 includes a plurality of battery cells, these plurality of battery cells may be connected in series, in parallel, or in a mixture of series and parallel.

The relay 20 is electrically connected in series to the battery 11 through a power path that connects the battery 11 and the inverter 30. In FIG. 1, the relay 20 is illustrated as connected between the positive terminal of the battery 11 and the charging and discharging terminals P+. The relay 20 is controlled to turn on and off in response to a switching signal from the battery management system 100. The relay 20 may be a mechanical contactor turned on and off by the magnetic force of the coil, or a semiconductor switch such as a MOSFET (Metal Oxide Semiconductor Field Effect transistor).

The inverter 30 is provided to convert DC current from the cell group 12 into AC current in response to commands from the battery management system 100 or the vehicle controller 2.

The electric motor 40 is driven using AC power from the inverter 30. As the electric motor 40, for example, a 3-phase AC motor 40 can be used.

The battery management system 100 includes a voltage sensor 111, a current sensor 113, a battery temperature sensor 115, and a control unit 130. The battery management system 100 may further include an outdoor air temperature sensor 117. The battery management system 100 may further include a communication circuit 150.

The voltage sensor 111 is connected in parallel to the battery 11, and is configured to detect the battery voltage, which is the voltage across both ends of the battery 11, and generate a voltage signal representing the detected battery voltage.

The current sensor 113 is connected in series to the battery 11 through the current path between the battery 11 and the inverter 30. The current sensor 113 is configured to detect battery current, which is the current flowing through the battery 11, and generate a current signal representing the detected battery current. The current sensor 113 may be implemented with one of known current detection elements such as a shunt resistor and a Hall effect element, or a combination of two or more of them.

The battery temperature sensor 115 is configured to detect battery temperature and generate a temperature signal representing the detected battery temperature. The battery temperature sensor 115 may be placed in the case 13 to detect a temperature close to the actual temperature of the battery 11. For example, the battery temperature sensor 115 may be attached to the surface of at least one battery cell BC included in the cell group 12, and may detect the surface temperature of the battery cell BC as the battery temperature.

The voltage sensor 111, the current sensor 113, and the battery temperature sensor 115 may be referred to as a 'sensing unit'.

The outdoor air temperature sensor 117 is configured to detect outdoor air temperature (atmosphere temperature), which is the temperature at a predetermined location spaced apart from the battery 11, and generate a temperature signal representing the detected outdoor air temperature. The outdoor air temperature sensor 117 may be placed at a predetermined location outside the case 13 where heat exchange occurs between the battery 11 and the outdoor air.

Each of the battery temperature sensor 115 and the outdoor air temperature sensor 117 may be implemented with one of known temperature detection elements such as thermocouples, thermistors, and bimetals, or a combination of two or more of them.

The communication circuit 150 is configured to support wired or wireless communication between the control unit 130 and the vehicle controller 2. Wired communication may be, for example, CAN (Controller Area Network) communication, and wireless communication may be, for example, ZigBee or Bluetooth communication. Of course, the type of communication protocol is not particularly limited as long as it supports wired and wireless communication between the control unit 130 and the vehicle controller 2. The communication circuit 150 may include an output device (e.g., display, speaker) that provides information received from the control unit 130 and/or the vehicle controller 2 in a form recognizable to the user.

The control unit 130 is operably coupled to the relay 20, the voltage sensor 111, the current sensor 113, the battery temperature sensor 115, the outdoor air temperature sensor 117, and the communication circuit 150. The operational combination of two components means that the two components are connected directly or indirectly to enable transmission and reception of signals in one direction or both directions.

The control unit 130 may collect a voltage signal from the voltage sensor 111, a current signal from the current sensor 113, a temperature signal from the battery temperature sensor 115 (can be referred to as a 'battery temperature signal'), and/or a temperature signal from the outdoor air temperature sensor 117 (can be referred to as an 'outdoor air temperature signal'). The control unit 130 may convert and record each analog signal collected from the sensors 111, 113, 115, 117 into digital values using an ADC (Analog to Digital Converter) provided therein.

The control unit 130 may be referred to as a 'control circuit' or a 'battery controller', and in terms of hardware, it may be implemented using at least one of ASICs (application specific integrated circuits), DSPs (digital signal processors), DSPDs (digital signal processing devices), PLDs (programmable logic devices), FPGAs (field programmable gate arrays), microprocessors, and other electrical units to perform functions.

The memory 140 may include at least one type of storage medium selected from, for example, flash memory type, hard disk type, SSD (Solid State Disk) type, SDD (Silicon Disk Drive) type, multimedia card micro type, RAM (random access memory), SRAM (static random access memory), ROM (read-only memory), EEPROM (electrically erasable programmable read-only memory), or PROM (programmable read-only memory). The memory 140 can store data and programs required for calculation operations by the control unit 130. The memory 140 can store data representing the result of an operation performed by the control unit 130. In FIG. 1, the memory 140 is shown as being physically independent from the control unit 130, but it may also be built in the control unit 130.

The memory 140 may store at least one reference charging map associated with the multi-stage constant-current charging protocol for the battery 11. Each reference charging map will be described in more detail below.

The control unit 130 may turn on the relay 20 in response to the key-on signal. The control unit 130 may turn off the relay 20 in response to the key-off signal. The key-off signal indicates a transition from a use state to an idle state. Alternatively, the vehicle controller 2 may be responsible for on-off control of the relay 20 instead of the control unit 130.

While the relay 20 is turned on, the battery 11 is in use. Conversely, while the relay 20 is turned off, the battery 11 is in an idle state. The use state is a state in which the battery 11 is being charged and discharged, and can also be referred to as a 'cycle state'. The idle state is a state in which charging and discharging of the battery 11 is stopped, and can also be called a 'calendar state'.

While the battery 11 is in use, the control unit 130 may determine a voltage detection value, a current detection value, a battery temperature detection value, and an outdoor air temperature detection value based on the voltage signal, the current signal, the battery temperature signal, and the outdoor air temperature signal, and then determine (estimate) the state of charge (SOC) of the battery 11 based on the voltage detection value, the current detection value, and/or the battery temperature detection value. SOC is the ratio of the remaining capacity to the fully charged capacity (maximum capacity) of the battery 11, and is usually processed in the range of 0 to 1 or 0% to 100%. To determine SOC, known methods such as ampere counting, OCV (Open Circuit Voltage)-SOC curve, and/or Kalman filter can be used. For reference, in this specification, simple description 'temperature detection value' may refer to a battery temperature detection value.

The maximum capacity of the battery 11 can be estimated using any one of various known methods or a combination two or more of them. As an example, the control unit 130 may calculate the current maximum capacity of the battery 11 by dividing the accumulated current amount over the period from when the SOC of the battery 11 is at the first value to when the SOC of the battery 11 reaches the second value by the change amount of SOC (i.e., the difference between the first value and the second value). Alternatively, the control unit 130 may determine the maximum capacity of the battery 11 by multiplying the SOH (State Of Health) calculated through any one of various known methods or a combination of two or more of them by a predetermined design capacity (maximum capacity of a new battery).

FIGS. 2 to 4 are diagrams referenced to explain an exemplary reference charging map used in a charging procedure using a multi-stage constant-current charging protocol.

A plurality of reference charging maps (CM₁ to CM_{N}) may be stored in the memory 140. The plurality of reference charging maps can be one-to-one related to the plurality of temperature sections (CM₁ to CM_{N}, N is a natural number greater than or equal to 2).

FIGS. 2 to 4 show a reference charging map (CMₙ, where n is a natural number less than or equal to N) among the plurality of reference charging maps (CM₁ to CM_{N}) associated with any one (e.g., 10°C or more and less than 25°C) among a plurality of temperature sections (e.g., less than 0°C, 0°C or more and less than 10°C, 10°C or more and less than 25°C, 25°C or more and less than 40°C, 40°C or more).

Specifically, the graph shown in FIG. 2 illustrates the reference current profile 200, which represents the change in charging current for SOC over the entire SOC range. In the present disclosure, the entire SOC range is partitioned into first to M^{th} SOC sections (Z[1] to Z[M], where M is a natural number greater than or equal to 2). For convenience of explanation, M = 4 is illustrated in FIGS. 2 to 4.

In the first to M^{th} SOC sections (Z[1] to Z[M]), the start point of the first SOC section (Z[1]) is the same as the start point of the entire SOC range (e.g., SOC 0%), and the end point of the M^{th} SOC section (Z[M]) is the same as the end point of the entire SOC range (e.g., SOC 100%). The end point of the entire SOC range can be set in advance as the target SOC.

Among two adjacent sections of the first to M^{th} SOC sections (Z[1] to Z[M]), the end point of the preceding section may match the start point of the following section. For example, the end point (e.g., 50%) of the first SOC section (Z[1]) matches the start point (e.g., 50%) of the second SOC section (Z[2]).

In FIG. 2, the first to M^{th} SOC sections (Z[1] to Z[M]) are one-to-one related to the first to M^{th} reference current values (I#1 to I#M), and each reference current value represents the charging current for constant-current charging in the SOC section associated therewith. According to the reference current profile 200, the reference current value for a specific SOC section is single, which indicates that the reference current value is for constant-current charging in the SOC section associated therewith. In other words, if the charger 3 can supply sufficiently large output power, the battery 11 can be constant-current charged by the charging current according to the reference current profile 200.

In the multi-stage constant-current charging protocol, the charging current may need to be reduced as SOC increases to protect the battery. Referring to FIG. 2, the first to fourth reference current values (I#1 to I#4) can be predetermined to decrease step by step, for example, to 8 [A], 6 [A], 4 [A], and 2 [A], as SOC increases.

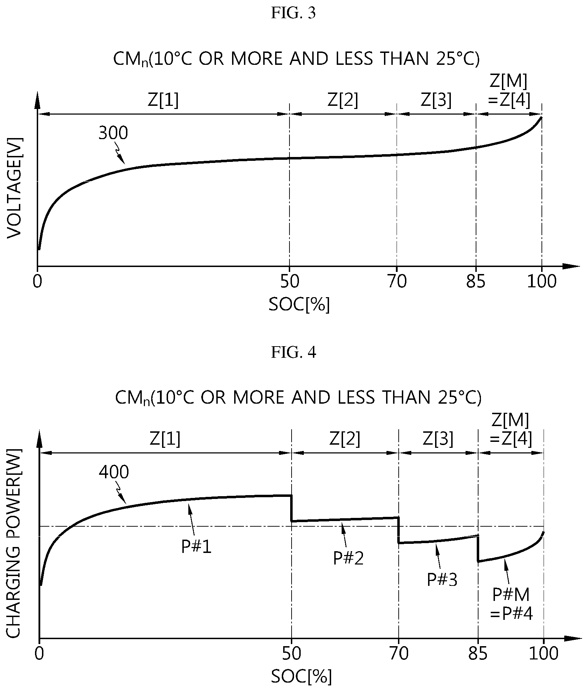

The graph shown in FIG. 3 illustrates the reference voltage profile 300, which represents the change in battery voltage for SOC over the entire SOC range. The reference voltage profile 300 may be obtained in advance from the result of repeatedly performing a charging test that periodically measures the voltage of each sample battery while charging at least one sample battery with the same specifications as the battery 11 according to the reference current profile 200. The reference voltage profile 300 can be recorded in the memory 140 as a time series or multi-order function of the battery voltage for the SOC.

The graph shown in FIG. 4 illustrates the reference power profile 400, which represents the change in charging power for SOC over the entire SOC range. The reference power profile 400 may be obtained in advance from the result of repeatedly performing a charging test that periodically measures the charging power supplied to each sample battery while charging at least one sample battery with the same specifications as the battery 11 according to the reference current profile 200. The reference power profile 400 may be recorded in the memory 140 as a time series or multi-order function of the charging power for the SOC.

The reference power profile 400 is practically equal to the product of the reference current profile 200 and the reference voltage profile 300 in the entire SOC range. That is, the charging power on the reference power profile 400 in a specific SOC is equal to the product of the voltage value on the reference voltage profile 300 and the current value on the reference current profile 200 in that specific SOC. Note that in each SOC section, the voltage of the battery 11 increases while the reference current value is constant, so the charging power gradually increases. A portion of the reference power profile 400, which represents the power change in a specific SOC section, will hereinafter be referred to as the 'reference power curve'. That is, the reference power profile 400 includes the successive first to fourth reference power curves (P#1 to P#4). For reference, in the reference current profile 200 shown in FIG. 2, the transition of the reference current value occurs at the boundary of two SOC sections, so among the first to fourth reference power curves (P#1 to P#4) shown in FIG. 4, it is shown that there is a deviation in charging power at each boundary of two adjacent reference power curves (e.g., P#2 and P#3).

Meanwhile, the reference charging map (CMₙ) associated with a specific temperature section may include the reference current profile 200, the reference voltage profile 300, and the reference power profile 400, which are obtained in advance through testing in the same temperature section.

Relatedly, to record the reference current profile 200, the reference voltage profile 300, and the reference power profile 400 all in the memory 140, a fairly large storage space is required. Additionally, it is possible to calculate (generate) the reference voltage profile (300, see FIG. 3) through the process of dividing the reference power profile (400, see FIG. 4) by the reference current profile (200, see FIG. 2). Therefore, at least one of the plurality of reference charging maps (CM₁ to CM_{N}) can be designed to include only the reference current profile 200 and the reference power profile 400.

To summarize the above, at least one reference charging map among the plurality of reference charging maps (CM₁ to CM_{N}) includes the first to M^{th} reference power curves (P#1 to P#M) and the first to M^{th} reference current values (I#1 to I#M) that are one-to-one associated with the first to M^{th} SOC sections (Z[1] to Z[M]).

In the same SOC section, the reference power curve of a reference charging map associated with one temperature section (e.g., 0°C or more and less than 10°C) may be different from a reference power curve of another reference charging map associated with another temperature section (e.g., 10°C or more and less than 25°C).

Likewise, in the same SOC section, the reference current value recorded in the reference charging map associated with one temperature section (e.g., 0°C or more and less than 10°C) may be different from the reference current value recorded in another reference charging map associated with another temperature section (e.g., 10°C or more and less than 25°C).

The relationship between charging current, battery voltage, and charging power with respect to the SOC and temperature of the battery 11 depends on the size, weight, active material, and appearance of the battery 11. Therefore, FIGS. 2 to 4 should be understood as a simple example in explaining the present disclosure.

For reference, the upper limit of the entire SOC range (i.e. target SOC) may be set to a value less than 100% (e.g. 98%). In this case, from the time the SOC of the battery 11 reaches the target SOC until it is fully charged, the battery 11 can be charged using the constant-voltage charging mode instead of the constant-current charging mode or constant-power charging mode.

Assume that m is a natural number less than or equal to M. In this specification, m is used as the section index of the SOC section to which the current SOC of the battery 11 belongs. Then, the symbol P#m used in this specification may represent the reference power curve associated with the SOC section (Z[m]) among the first to M^{th} reference power curves (P#1 to P#M) recorded in the reference charging map (CMn) associated with the temperature section to which the battery temperature (detection value or predicted value) belongs. Additionally, the symbol I#m may represent the reference current value associated with the SOC section (Z[m]). Each reference current value (e.g., I#1) may be a predetermined value that represents the maximum charging current allowed for charging the battery 11 without irreversible damage from the start point (e.g., 0 %) to the end point (e.g., 50 %) of the SOC section (e.g., Z[1]) associated therewith.

When x is a natural number of M or less, the size (width) of the SOC section (Z[x]) is the difference between the start point and the end point of the SOC section (Z[x]), and the sign ΔZ[x] used. In FIGS. 2 to 4, the sizes of the first to fourth SOC sections (Z[1] to Z[4]) are illustrated as 50%, 20%, 15%, and 15% in that order. Of course, it should be understood that the first to M^{th} SOC sections (Z[1] to Z[M]) may have the same size or be determined differently from FIG. 2.

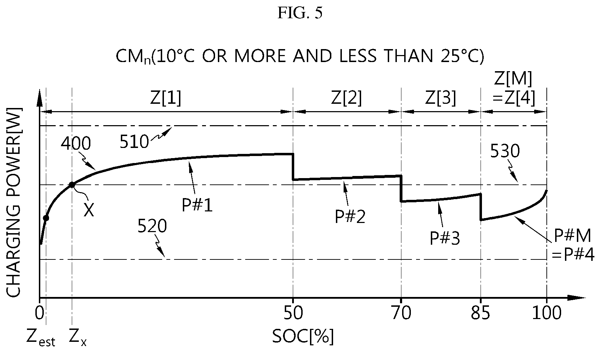

FIG. 5 is a diagram referenced to explain the effect of the maximum output power of the charger on the charging procedure using the multi-stage constant-current charging protocol.

FIG. 5 shows three horizontal lines 510, 520, 530 along with the reference power profile 400 of FIG. 4. Any one of these three horizontal lines 510, 520, 530 represents the maximum output power (P_{MAX}) that can be supplied from the charger 3 to the battery 11. The control unit 130 may identify the maximum output power (P_{MAX}) of the charger 3 from the vehicle controller 2 and/or the charger 3 through the communication circuit 150.

In any of the constant-current charging mode, the constant-power charging mode, and the constant-voltage charging mode, the voltage of the battery 11 gradually increases during charging by the corresponding charging mode in each SOC section.

The horizontal line 510 illustrates that the maximum output power (P_{MAX}) that can be supplied from the charger 3 to the battery 11 is greater than or equal to the maximum charging power required for the entire SOC section. In FIG. 5, it is shown that the maximum charging power is required at the end point of the SOC section (Z[1]). In this case, only the constant-current charging mode in which different charging currents (I#1 to I#M) are sequentially switched according to the multi-stage constant-current charging protocol will be implemented. In other words, in the SOC section (Z[x]), the battery 11 is charged constant-currently with the charging current of the reference current value (I[x]), so the temporal change in the charging power supplied to the battery 11 can be treated as matching the reference power profile 400.

The horizontal line 520 illustrates that the maximum output power (P_{MAX}) of the charger 3 is less than or equal to the minimum charging power required for the entire SOC section. In FIG. 5, it is shown that the minimum charging power is required at the start point of the SOC section (Z[1]). In this case, the charging power supplied to the battery 11 over the entire SOC section is limited to the maximum output power (P_{MAX}) of the charger 3. In other words, instead of sequentially switching different charging currents according to the multi-stage constant-current charging protocol, only the constant-power charging mode based on the maximum output power (P_{MAX}) will be implemented until reaching the end point from the start point of the entire SOC section.

The horizontal line 530 illustrates a situation where the maximum output power (P_{MAX}) of the charger 3 is greater than the minimum charging power required for the entire SOC section and less than the maximum charging power.

Looking at the horizontal line 530, the maximum output power (P_{MAX}) is located on the upper side of the reference power curve (P#1) at the beginning of the SOC section (Z[1]), and then is located below the reference power curve (P#1) from a specific SOC (Z_{X}). In other words, there is an intersection point (X) between the horizontal line 530 and the reference power curve (P#1) within the SOC section (Z[1]). This intersection point (X) is a transition point from the constant-current charging mode by the reference current value (I#1) to the constant-power charging mode by the maximum output power (P_{MAX}).

Additionally, in the SOC section (Z[2]), the maximum output power (P_{MAX}) is below the reference power curve (P#1), while in the SOC section (Z[3]) and the SOC section (Z[4]), the maximum output power (P_{MAX}) is above the reference power curve (P#3) and the reference power curve (P#4). Therefore, in the SOC section (Z[2]), the battery 11 is charged in the constant-power charging mode by the maximum output power (P_{MAX}), and in the SOC section (Z[3]) and the SOC section (Z[4]), the battery 11 is charged in the constant-current charging mode according to the reference current value (I#3) and the reference current value (I#4).

Conventionally, there was no way to reflect the fact that the charging power supplied to the battery 11 during charging is limited to the maximum output power (P_{MAX}) of the charger 3 to the process of predicting the remaining charging time. For example, even if the maximum output power (P_{MAX}) of the charger 3 is equal to the horizontal line 530 shown in FIG. 5, in predicting the remaining charging time in each of the two SOC sections (Z[1], Z[2]), assuming that the charging power is supplied according to the reference power curves (P#1, P#2), the prediction error of the remaining charging time is accumulated by the power difference between the charging power according to the reference power curves (P#1, P#2) in the latter half (Z_{X} to 50%) of the SOC section (Z[1]) and the entire SOC section (Z[2]) and the maximum output power (P_{MAX}) of the charger 3. As a result, situations where the predicted value of the remaining charging time for the two SOC sections (Z[1], Z[2]) as well as the total remaining charging time until reaching the target SOC is significantly different from the actual value frequently occur.

Therefore, in order to reduce the prediction error of the remaining charging time for each SOC section, by comparing the charging power according to the reference power profile 400 with the maximum output power (P_{MAX}) of the charger 3 for each SOC section, it is necessary to determine whether to implement any one of the constant-current charging mode and the constant-power charging mode or to implement both of them, and then calculate (predict) the remaining charging time for each SOC section using the characteristics of the determined charging mode.

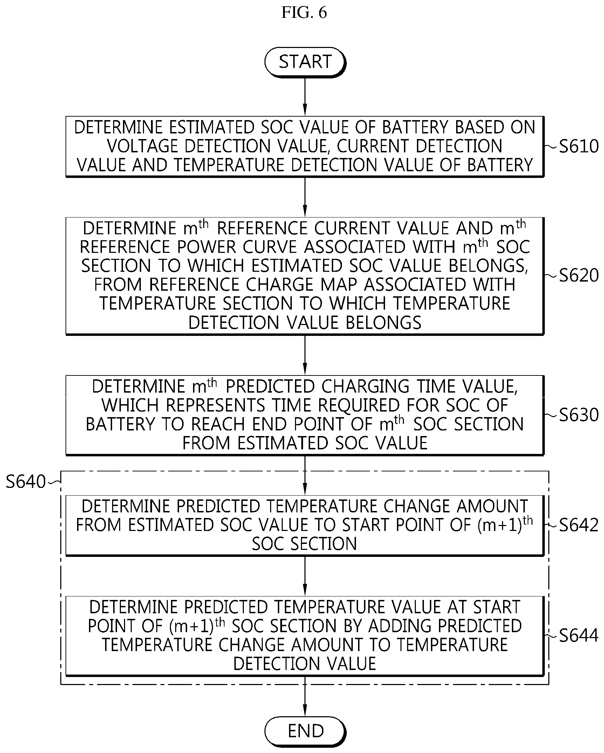

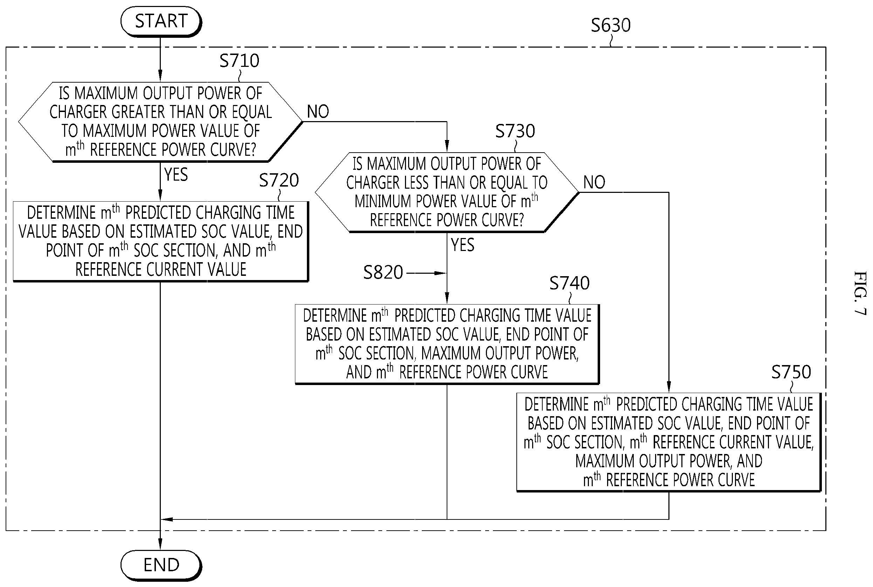

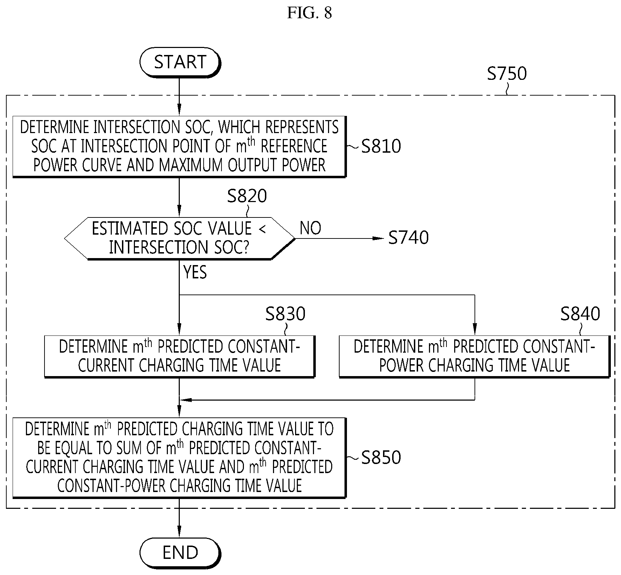

FIG. 6 is a flowchart exemplarily illustrating a battery charging time prediction method according to the first embodiment of the present disclosure, FIG. 7 is a flowchart illustrating the subroutines of step S630 shown in FIG. 6, and FIG. 8 is a flowchart illustrating the subroutines of step S750 shown in FIG. 7. The method of FIG. 6 may be executed by the battery management system 100 at every set time while charging the battery 11 using the multi-stage constant-current charging protocol.

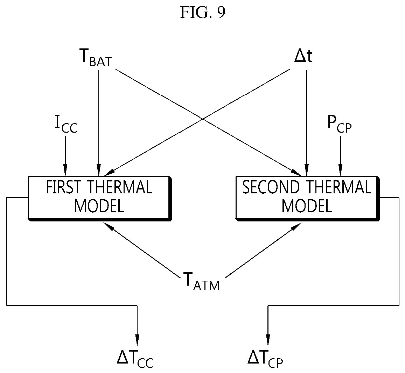

Referring to FIGS. 1 to 6, in step S610, the control unit 130 determines the estimated SOC value of the battery 11 based on the voltage detection value and the current detection value of the battery 11. The battery temperature detection value can be additionally used to determine the estimated SOC value. The voltage detection value, the current detection value, the temperature detection value, and the estimated SOC value in step S610 may represent current voltage, current, temperature, and SOC of the battery 11, respectively. The control unit 130 records the voltage detection value, the current detection value, the temperature detection value, and the estimated SOC value determined at each setting time in the memory 140. In step S610, the outdoor air temperature detection value (T_{ATM}, see FIG. 9) indicating the current outdoor air temperature may be additionally determined.

In step S620, the control unit 130 obtains the m^{th} reference current value (I#m) and the m^{th} reference power curve (P#m) associated with the SOC section (Z[m], where m is a natural number less than or equal to M) to which the estimated SOC value determined in step S610 belongs from the reference charging map (CMₙ) associated with the temperature section to which the temperature detection value belongs among the plurality of reference charging maps (CM₁ to CM_{N}). In this specification, the m^{th} SOC section (Z[m]) may refer to the SOC section to which the current SOC of the battery 11 belongs.

In step S630, the control unit 130 determines the m^{th} predicted charging time value, which represents the time required for the SOC of the battery 11 to reach the end point of the m^{th} SOC section (Z[m]) from the estimated SOC value determined in step S610, based on the estimated SOC value and the end point of the m^{th} SOC section (Z[m]), and further based on at least one of the m^{th} reference current value (I#m), the maximum output power (P_{MAX}), and the m^{th} reference power curve (P#m), according to the comparison result of the maximum output power (P_{MAX}) and the m^{th} reference power curve (P#m). For example, if the estimated SOC value determined in step S610 is 2%, the m^{th} SOC section (Z[m]) = Z[1], and the m^{th} predicted charging time value (first predicted charging time value) may be the time required for the SOC of the battery 11 to reach 50% from 2%. Step S630 includes step S710 to step S750 as its subroutines.

Referring to FIG. 7, in step S710, the control unit 130 determines whether the maximum output power (P_{MAX}) of the charger 3 is greater than or equal to the maximum power value of the m^{th} reference power curve (P#m). For example, if the horizontal line 510 in FIG. 5 indicates the maximum output power (P_{MAX}), the value of step S710 is "Yes." On the other hand, if the horizontal line 520 or the horizontal line 530 in FIG. 5 indicates the maximum output power (P_{MAX}), the value of step S710 is "No". If the value of step S710 is "Yes," the process proceeds to step S720. If the value of step S710 is "No", the process proceeds to step S730.

In step S720, the control unit 130 determines the m^{th} predicted charging time value based on the estimated SOC value, the end point of the m^{th} SOC section (Z[m]), and the m^{th} reference current value (I#m). The SOC difference (ΔZ[m]) is a value obtained by subtracting the estimated SOC value from the end point of the m^{th} SOC section (Z[m]). The m^{th} predicted charging time value determined through step S720 may represent the charging time by the constant-current charging mode. The control unit 130 may determine the m^{th} predicted charging time value by calculating the required charging capacity corresponding to the SOC difference (ΔZ[m]) and then dividing the calculated required charging capacity by the m^{th} reference current value (I#m).

Equation 1 below is an example of a function that can be used to determine charging time by the constant-current charging mode. <Equation 1> $Δ {t}_{CC} = \frac{Δ Q}{{I}_{CHG}} = \frac{Δ z \times {Q}_{MAX}}{{I}_{CHG}} = \frac{\left({z}_{f}-{z}_{i}\right) \times {Q}_{MAX}}{{I}_{CHG}}$

In Equation 1, z = SOC, z_{f} = SOC to be reached through charging, zᵢ = SOC at a specific point before reaching z_{f}, I_{CHG} = charging current, Q_{MAX} = maximum capacity of the battery 11, ΔQ = capacity required for charging = Δz = capacity corresponding to (z_{f} - zi), and Δt_{CC} = charging time. For reference, Equation 1 is expressed using three equal signs to aid understanding, but it can be stored in the memory 140 to include only the rightmost term among the three terms on the right.

As an example, assume Q_{MAX} = 10000 mAh, z_{f} - zᵢ = end point of the m^{th} SOC section (Z[m]) - estimated SOC value = 50% - 2% = ΔZ[m] = 48%, and I#m = 10 A. Then, since ΔQ = 4800 mAh, Δt#m = 4800 mAh/10 A = 0.48 hours.

In step S730, the control unit 130 determines whether the maximum output power (P_{MAX}) of the charger 3 is less than or equal to the minimum power value of the m^{th} reference power curve (P#m). For example, if the horizontal line 520 in FIG. 5 indicates the maximum output power (P_{MAX}), the value of step S730 is "Yes." On the other hand, if the horizontal line 530 in FIG. 5 indicates the maximum output power (P_{MAX}), the value of step S730 is "No". If the value of step S730 is "Yes," the process proceeds to step S740. The value of step S730 being "No" means that the maximum output power (P_{MAX}) of the charger 3 is between the minimum power value and the maximum power value of the m^{th} reference power curve (P#m). If the value of step S730 is "No", the process proceeds to step S750.

In step S740, the control unit 130 determines the m^{th} predicted charging time value based on the estimated SOC value, the end point of the m^{th} SOC section (Z[m]), the maximum output power (P_{MAX}), and the m^{th} reference power curve (P#m). The m^{th} predicted charging time value determined through step S740 may be the charging time by the constant-power charging mode. Equation 2 below is an example of a function that can be used to determine the charging time by the constant-power charging mode. <Equation 2> $\begin{matrix}{Δt}_{CP} = \frac{Δ {Wh}_{CP}}{{P}_{CP}} = \left\{ΔQ\times \frac{{\int }_{{z}_{i}}^{{z}_{f}} V \left(z\right) dz}{{z}_{f} - {z}_{i}}\right\} \times \frac{1}{{P}_{CP}} = \left\{ΔQ\times \frac{{\int }_{{z}_{i}}^{{z}_{f}} \frac{{P}_{CHG} \left(z\right)}{{I}_{CHG}} dz}{{z}_{f} - {z}_{i}}\right\} \times \frac{1}{{P}_{CP}} \\ = \left\{ΔQ\times {V}_{av}\right\} \times \frac{1}{{P}_{CP}}\end{matrix}$

In Equation 2, z = SOC, z_{f} = SOC to be reached through charging, zᵢ = SOC at a specific point before reaching z_{f}, I_{CHG} = charging current, V(z) = voltage estimate value of the battery 11 at z during constant-current charging with I_{CHG}, V_{AV} = average of V(z) in the range of zᵢ to z_{f}. P_{CHG}(z) = charging power at z during constant-current charging with I_{CHG}, P_{CP} = charging power actually supplied (constant power), ΔWh_{CP} = required charging energy, ΔQ = required charging capacity, and Δt_{CP} = charging time. For reference, the unit of ΔWh_{CP} may be Wh (Watt-hour). For reference, Equation 2 is expressed using four equal signs to aid understanding, but it can be stored in the memory 140 to include only the rightmost term among the four terms on the right.

Assume that the maximum capacity of the battery 11 = 10000 mAh, the estimated SOC value is 2%, and the maximum output power (P_{MAX}) matches the horizontal line 520 in FIG. 5. Then, in Equation 2, zᵢ = 2%, z_{f} = 50%, z_{f} - zᵢ = ΔZ[1] = 48%, Q = 4800 mAh, I_{CHG} = I#1 = 10 A, and P_{CHG} (z) = P#1. If V_{AV} = 3.3 V and P_{CP} = P_{MAX} = 20 W (Watt), Δt_{CP} = {4800 mAh × 3.3 V} /20 W = 0.792 hour = Δt#1.

In step S750, the control unit 130 determines the m^{th} predicted charging time value (Δt#m) based on the estimated SOC value, the end point of the m^{th} SOC section (Z[m]), the m^{th} reference current value (I#m), the maximum output power (P_{MAX}), and the m^{th} reference power curve (P#m).

Step S750 includes step S810 to step S850 as its subroutines.

Referring to FIG. 8, in step S810, the control unit 130 determines the intersection SOC, which represents the SOC at the intersection point of the m^{th} reference power curve (P#m) and the maximum output power (P_{MAX}). Referring to FIG. 5, when the maximum output power (P_{MAX}) matches the horizontal line 530, X represents the intersection point and Zx represents the intersection SOC.

In step S820, the control unit 130 determines whether the intersection SOC (Zx) is greater than the estimated SOC value (current SOC). If the value of step S820 is "Yes," the process proceeds to step S830 and step S840. The value of step S820 being "No" means that only the constant-power charging mode, in which the charging power is limited to maximum output power (P_{MAX}), will be implemented from now until the end point of the m^{th} SOC section (Z[m]). If the value of step S820 is "No", the process may proceed to step S740 of FIG. 7.

In step S830, the control unit 130 determines the m^{th} predicted constant-current charging time value, which represents the time required for the SOC of the battery 11 to reach the intersection SOC (Z_{X}) from the estimated SOC value, based on the estimated SOC value, the intersection SOC (Z_{X}), and the m^{th} reference current value (I#m). Equation 1 described above can be used to determine the m^{th} predicted constant-current charging time value. In other words, assuming that the current SOC is 2%, Δt_{CC} when the intersection SOC (Z_{X}) is entered instead of 50% of the end point of the first SOC section (Z[1]) as z_{f} in Equation 1 is determined as the m^{th} predicted constant-current charging time value.

In step S840, the control unit 130 determines the m^{th} predicted constant-power charging time value, which represents the time required for the SOC of the battery 11 to reach the end point of the m^{th} SOC section (Z[m]) from the intersection SOC (Z_{X}), based on the intersection SOC (Z_{X}), the end point of the m^{th} SOC section (Z[m]), the maximum output power (P_{MAX}), and the m^{th} reference power curve (P#m).

Equation 2 described above can be used to determine the m^{th} predicted constant-power charging time value. In other words, when Z_{X} > 2% = current SOC, Δt_{CP} when the intersection SOC (Z_{X}) is input instead of the estimated SOC value as zᵢ in Equation 2 is determined as the m^{th} predicted constant-power charging time value.

In step S850, the control unit 130 determines the m^{th} predicted charging time value to be equal to the sum of the m^{th} predicted constant-current charging time value determined in step S830 and the m^{th} predicted constant-power charging time value determined in step S840.

Step S640 described from now on can be executed on the condition that m is less than M. The fact that m, which is the section index of the SOC section to which the current SOC belongs, is less than M means that there is at least one SOC section following the m^{th} SOC section (Z[m]) in which the charging procedure is currently in progress. For example, when m = 1 < 4 = M, since charging is scheduled in three SOC sections (Z[2] to Z[4]), step S640 may be performed.

In step S640, the control unit 130 determines the predicted temperature value at the start point of the (m+1)^{th} SOC section (Z[m+1]), based on the battery temperature detection value and the m^{th} predicted charging time value (Δt#m), and further based on at least one of the m^{th} reference current value (I#m) and the maximum output power (P_{MAX}). The predicted temperature value at the start point of the (m+1)^{th} SOC section (Z[m+1]) represents the temperature of the battery 11 at the end point of the m^{th} SOC section (Z[m]). If the outdoor air temperature detection value (T_{ATM}) is additionally obtained in step S610, in step S640, further based on the outdoor air temperature detection value (T_{ATM}), the predicted temperature value at the start point of the (m+1)^{th} SOC section (Z[m+1]) can be determined.

Step S640 may include step S642 and step S644.

In step S642, the control unit 130 determines the predicted temperature change amount during the period from the estimated SOC value representing the current SOC of the battery 11 until reaching the start point of the (m+1)^{th} SOC section (Z[m+1]). At least one of the first thermal model and the second thermal model described later may be used to determine the predicted temperature change amount.

In step S644, the control unit 130 determines the predicted temperature value at the start point of the (m+1)^{th} SOC section (Z[m+1]) to be the same as the sum of the predicted temperature change amount (e.g., ΔT_{CC}, ΔT_{CP}, or ΔT_{CC}+ΔT_{CP} in FIG. 9) determined in step S642 and the temperature detection value obtained in step S610.

FIG. 9 is a schematic diagram referenced to explain the first and second thermal models used to predict the temperature change amount for each SOC section according to the multi-stage constant-current charging protocol.

In FIG. 9, T_{BAT} is the battery temperature (detection value or predicted value), Δt is the charging time, I_{CC} is the constant current, P_{CP} is the maximum output power (P_{MAX}) of the charger 3, and T_{ATM} is the outdoor air temperature detection value.

The control unit 130 may calculate the predicted temperature change amount indicating the temperature change amount until the SOC of the battery 11 within a specific SOC section reaches the end point of the corresponding SOC section, using at least one of the first thermal model and the second thermal model.

The first thermal model may use Equation 3 illustrated below as the first thermal model as a predetermined function to output the temperature change amount (ΔT_{CC}) by the constant-current charging mode in response to the values of the input variables (T_{BAT}, Δt, I_{CC}, T_{ATM}) assigned by the control unit 130. <Equation 3> $Δ {T}_{CC} = \frac{\left\{\left(α\times {{I}_{CC}}^{2}\right)+\frac{{T}_{ATM} - {T}_{BAT}}{β}\right\}}{{C}_{H}} \times Δ t$

In Equation 3, α represents the adjustment coefficient (predetermined), β represents the heat exchange coefficient (predetermined), and C_{H} represents the heat capacity of the battery 11 (predetermined). For the first thermal model, T_{ATM} may be a predetermined value (e.g., 25°C) instead of the outdoor air temperature detection value.

Equation 3 is just an example of the first thermal model, and the first thermal model is not limited to Equation 3 above. In other words, if a positive correlation is given between each of the input variables I_{CC}, Δt, and the difference between T_{ATM} and T_{BAT}, and the output variable ΔT_{CC}, in accordance with the heat generation characteristics of the battery 11 in the constant-current charging mode, a function or algorithm other than Equation 3 can be used as the first thermal model.

The second thermal model may use Equation 4 illustrated below as the second thermal model as a predetermined function to output the temperature change amount (ΔT_{CP}) by the constant-power charging mode in response to the values of the input variables (T_{BAT}, Δt, P_{CP}, T_{ATM}) assigned by the control unit 130. <Equation 4> $Δ {T}_{CP} = \frac{\left\{\left(γ\times {P}_{CP}\right)+\frac{{T}_{ATM} - {T}_{BAT}}{β}\right\}}{{C}_{H}} \times Δ t$

In Equation 4, γ is the adjustment coefficient (predetermined), and the remaining variables and coefficients are the same as in Equation 3.

Equation 4 is only an example of the second thermal model, and the second thermal model is not limited to Equation 4 above. In other words, if a positive correlation is given between each of the input variables P_{CP}, Δt, and the difference between T_{ATM} and T_{BAT}, and the output variable ΔT_{CP}, in accordance with the heat generation characteristics of the battery 11 in the constant-power charging mode, a function or algorithm other than Equation 4 can be used as the second thermal model.

Referring to FIGS. 5 and 9 together, when the estimated SOC value (Zₑₛₜ) is less than intersection SOC (Z_{X}), the sum of ΔT_{CC} output when inputting the m^{th} predicted constant-current charging time value into Δt in Equation 3 and ΔT_{CP} output when inputting the m^{th} predicted constant-power charging time value into Δt in Equation 4 can be determined as the predicted temperature change amount in the SOC section (Z[1]). If the estimated SOC value (Zₑₛₜ) is greater than or equal to the intersection SOC (Z_{X}), ΔT_{CP} in Equation 4 can be determined as the predicted temperature change amount in the SOC section (Z[1]). Additionally, the predicted temperature change amount in the SOC section (Z[2]) can be determined by Equation 4. The predicted temperature change amount in each of the remaining two SOC sections (Z[3], Z[4]) can be determined by Equation 3.

Referring back to FIG. 7, step S720, step S740, and step S750 are performed alternatively.

When step S720 is executed, the control unit 130 may determine the predicted temperature value at the start point of the (m+1)^{th} SOC section (Z[m+1]) by assigning the battery temperature detection value, the m^{th} predicted charging time value, and the m^{th} reference current value (I#m) to the input variables (T_{BAT}, Δt, I_{CC}) of the first thermal model, respectively, and adding the temperature detection value to the temperature change amount (ΔT_{CC}) output from the first thermal model.

When step S740 is executed, the control unit 130 may determine the predicted temperature value at the start point of the (m+1)^{th} SOC section (Z[m+1]) by assigning the battery temperature detection value, the m^{th} predicted charging time value, and the maximum output power (P_{MAX}) to the input variables (T_{BAT}, Δt, P_{CP}) of the second thermal model, respectively, and adding the temperature detection value to the temperature change amount (ΔT_{CP}) output from the second thermal model.

When step S750 is executed, the control unit 130 may determine the predicted temperature value in the intersection SOC (Z_{X}) by assigning the battery temperature detection value, the m^{th} predicted constant-current charging time value (Δt_{CC} in Equation 1), and the m^{th} reference current value (I#m) to the input variables (T_{BAT}, Δt, I_{CC}) of the first thermal model, respectively, and adding the battery temperature detection value to the temperature change amount (ΔT_{CC}) output from the first thermal model. Subsequently, the control unit 130 may determine the predicted temperature value at the start point of the (m+1)^{th} SOC section (Z[m+1]) by assigning the battery temperature detection value, the m^{th} predicted constant-power charging time value (Δt_{CP} of Equation 2) and the m^{th} reference current value (I#m) in the intersection SOC (Z_{X}) to the input variables (T_{BAT}, Δt, P_{CP}) of the second thermal model, respectively, and adding the predicted temperature value in the intersection SOC (Z_{X}) to the temperature change amount (ΔT_{CP}) output from the second thermal model.

The operation of calculating the predicted temperature change amount for the SOC section (Z[k], where k is a natural number greater than m and less than M) that follows the current SOC section (Z[m]) is common to the operation of calculating the predicted temperature change amount in the SOC section (Z[m]) described above, except that the predicted battery temperature value at the start point of the following SOC section (Z[k]) is assigned as T_{BAT} in FIG. 9, and the reference current value (I#k) associated with the following SOC section (Z[k]) is assigned as I_{CC} in FIG. 9.

The predicted temperature value at the start point of the SOC section (Z[k]) is used to specify one reference charging map (CMᵤ, u is a natural number less than or equal to N) among the plurality of reference charging maps (CM₁ to CM_{N}), and obtain the k^{th} reference power curve (P#k) and the k^{th} reference current value (I#k) from the specified reference charging map (CMᵤ).

The control unit 130 may perform the above-described process for each SOC section until the predicted charging time value for the last SOC section (e.g., Z[M]) to which the target SOC belongs is determined. Accordingly, the predicted charging time value for each of the current SOC section (Z[m]) to the last SOC section (Z[M]) can be sequentially determined. Therefore, by adding all the predicted charging time values determined for the current SOC section (Z[m]) to the last SOC section (Z[M]), the total remaining time required to reach the target SOC from the current SOC can be determined.

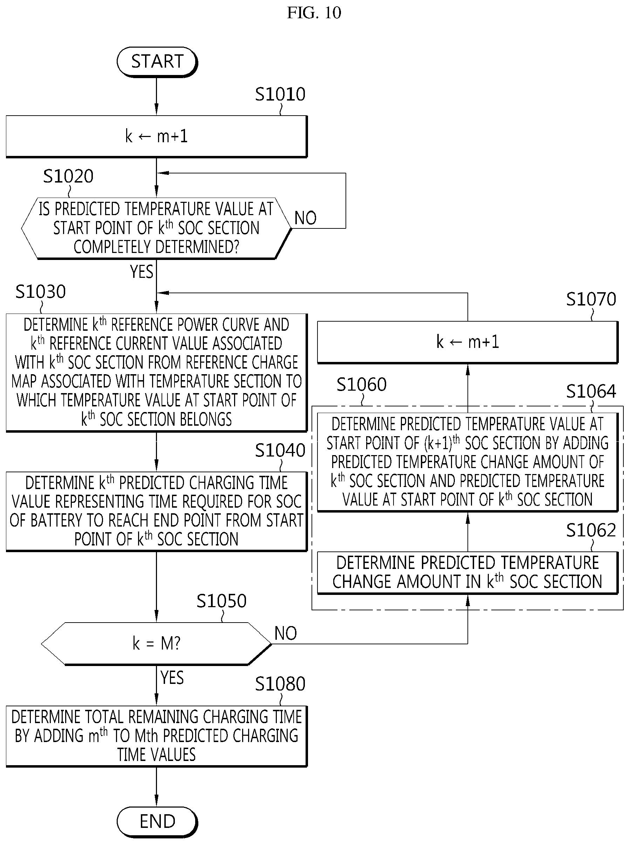

FIG. 10 is a flowchart exemplarily illustrating a battery charging time prediction method according to the second embodiment of the present disclosure. The method of FIG. 10 may be executed subsequent to the method of FIG. 5, on the condition that m is less than M. If m is less than M, it means that among the first to M^{th} SOC sections (Z[1] to Z[M]), there is at least one SOC section following the m^{th} SOC section (Z[m]) to which the current SOC belongs.

Referring to FIGS. 1 to 10, in step S1010, the control unit 130 sets the section index k equal to (m+1).

In step S1020, the control unit 130 determines whether the determination of the predicted temperature value at the start point of the k^{th} SOC section (Z[k]) has been completed. If the value of step S1020 is "Yes," the process proceeds to step S1030. If the value of step S1020 is "No," the process may wait until the value of step S1020 becomes "Yes."

In step S1030, the control unit 130 determines the k^{th} reference power curve (P#k) and the k^{th} reference current value (I#k) associated with the k^{th} SOC section (Z[k]) from any one reference charging map (CMᵤ) among the plurality of reference charging maps (CM₁ to CM_{N}) associated with one temperature section to which the predicted temperature value at the start point of the k^{th} SOC section (Z[k]) belongs among the plurality of temperature sections.

In step S1040, the control unit 130 determines the k^{th} predicted charging time value representing the time required for the SOC of the battery 11 to reach the end point of the k^{th} SOC section (Z[k]) from the start point of the k^{th} SOC section (Z[k]), based on the size (ΔZ) of the k^{th} SOC section (Z[k]), and further based on at least one of the k^{th} reference current value (I#k), the maximum output power (P_{MAX}), and the k^{th} reference power curve (P#k).

The operation of determining the k^{th} predicted charging time value is common with the operation described above with reference to FIGS. 7 and 8, except that the section index m is replaced by k, and the estimated SOC value is replaced by the start point of the k^{th} SOC section (Z[k]).

In step S1050, the control unit 130 determines whether the section index k is equal to M. M can be said to be the identification number of the last SOC section (Z[M]) to which the target SOC belongs. The fact that the section index k is equal to M means that the determination of the predicted charging time value for the last SOC section (Z[M]) has been completed. If the value of step S1050 is "No", the process proceeds to step S1060. If the value of step S 1050 is "Yes," the process proceeds to step S1080.

In step S1060, the control unit 130 may determine the predicted temperature value at the start point of the (k+1)^{th} SOC section (Z[k+1]), based on the predicted temperature value and the k^{th} predicted charging time value at the start point of the k^{th} SOC section (Z[k]), and further based on at least one of the k^{th} reference current value (I#k) and the maximum output power (P_{MAX}).

Step S1060 may include step S1062 and step S1064.

In step S1062, the control unit 130 determines the predicted temperature change amount for the period until the SOC of the battery 11 reaches the start point of the (k+1)^{th} SOC section (Z[k+1]) from the start point of the k^{th} SOC section (Z[k]). At least one of the above-described first thermal model and second thermal model may be used to determine the predicted temperature change amount in the SOC section (Z[k]).

In step S1064, the control unit 130 determines the predicted temperature value at the start point of the (k+1)^{th} SOC section (Z[k+1]) to be equal to the sum of the predicted temperature change amount determined in step S1062 and the predicted temperature value at the start point of the k^{th} SOC section (Z[k]).

In step S1070, the control unit 130 increases the section index k by 1 and then returns to step S1030. That is, steps S1030 to S1070 can be repeated until k reaches M.

In step S1080, the control unit 130 determines the total remaining charging time until the charging procedure using the multi-stage constant-current charging protocol is terminated (i.e., until the SOC of the battery reaches the target SOC) by adding the m^{th} to M^{th} predicted charging time values. The m^{th} to M^{th} predicted charging time values correspond one-to-one to the m^{th} to M^{th} SOC sections (Z[m] to Z[M]).

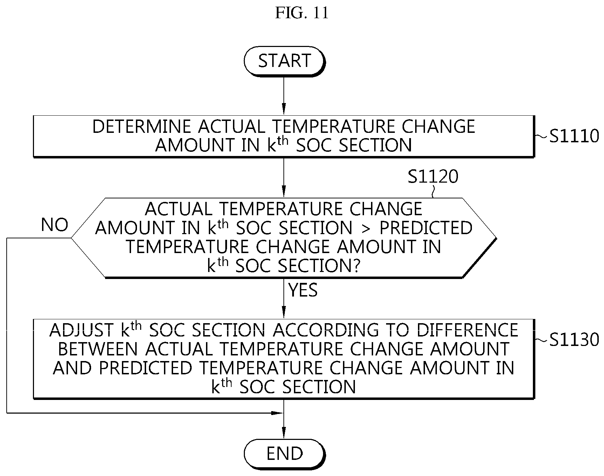

FIG. 11 is a flowchart exemplarily illustrating a battery charging time prediction method according to the third embodiment of the present disclosure. The method of FIG. 11 can be executed to adjust the corresponding SOC section, provided that constant-current charging for at least one SOC section for which the predicted charging time value has been determined by any one of the first and second embodiments described above with reference to FIGS. 6 to 10 is actually completed. In explaining FIG. 11, it will be assumed that j is a natural number greater than or equal to m and less than or equal to M.

Referring to FIGS. 1 to 11, in step S1110, the control unit 130 determines the actual temperature change amount in the j^{th} SOC section (Z[j]). If the j^{th} SOC section (Z[j]) is the SOC section (e.g., Z[m]) at the charging start point using the multi-stage constant-current charging protocol, the difference between the battery temperature detection value at the charging start point and the battery temperature detection value at the end point of the SOC section (Z[m]) may be determined as the actual temperature change amount in the SOC section (Z[m]). Or, if the j^{th} SOC section (Z[j]) is a SOC section (e.g., Z[M]) different from the SOC section (e.g., Z[m]) at the charging start point, the difference between two battery temperature detection values at the start point and the end point of the SOC section (Z[M]) may be determined as the actual temperature change amount in the SOC section (Z[M]).

In step S1120, the control unit 130 determines whether the actual temperature change amount in the j^{th} SOC section (Z[j]) is greater than the predicted temperature change amount in the j^{th} SOC section (Z[j]).

Alternatively, the control unit 130 may correct the predicted temperature change amount in the j^{th} SOC section (Z[j]) based on the two outdoor air temperature detection values at the start point and the end point of the j^{th} SOC section (Z[j]), and then compare the corrected predicted temperature change amount with the actual temperature change amount in the j^{th} SOC section (Z[j]). Specifically, when determining the predicted temperature change amount in the j^{th} SOC section (Z[j]), T_{ATM} in Equation 3 may represent the outdoor air temperature at the start point of the j^{th} SOC section (Z[j]). Since the outdoor air temperature may change in the j^{th} SOC section (Z[j]), the predicted temperature change amount in the j^{th} SOC section (Z[j]) can be corrected by calculating the temperature correction value using Equation 5 below and then adding the temperature correction value to the predicted temperature change amount in the j^{th} SOC section (Z[j]). <Equation 5> $Δ {T}_{correct} = \frac{\frac{\left({T}_{ATM _ 2}-{T}_{ATM _ 1}\right)}{β}}{{C}_{H}} \times Δ t$

In Equation 5, T_{ATM_1} may be the outdoor air temperature detection value at the start point of the j^{th} SOC section (Z[j]), and T_{ATM_2} may be the outdoor air temperature detection value at the end point of the j^{th} SOC section (Z[j]). The values of other parameters are common to Equation 4. According to Equation 5, if T_{ATM_2} > T_{ATM_1}, ΔT_{correct} is positive, and the predicted temperature change amount in the j^{th} SOC section (Z[j]) increases through correction. Conversely, if T_{ATM_2} < T_{ATM_1}, ΔT_{correct} is negative, and the predicted temperature change amount in the j^{th} SOC section (Z[j]) decreases through correction.

If the value of step S1120 is "Yes," the process proceeds to step S1130.

In step S1130, the control unit 130 adjusts the j^{th} SOC section (Z[j]) according to the difference between the actual temperature change amount and the predicted temperature change amount in the j^{th} SOC section (Z[j]).

As an example, the control unit 130 may decrease the end point of the j^{th} SOC section (Z[j]) by an adjustment value that has a predetermined positive correlation with respect to the difference. Accordingly, the size of the j^{th} SOC section (Z[j]) is reduced by the adjustment value. In addition, the fact that the end point of the j^{th} SOC section (Z[j]) is advanced by the adjustment value means that the start point of the (j+1)^{th} SOC section (Z[j+1]) is also advanced by the adjustment value. Therefore, the size of the (j+1)^{th} SOC section (Z[j+1]) is increased by the adjustment value.

According to the third embodiment described above with reference to FIG. 11, when the multi-stage constant-current charging protocol is carried out in the future, the charging procedure for the SOC section with a history of temperature rise exceeding expectations is terminated early, and the charging procedure for the SOC section following the corresponding SOC section is started early. As can be seen from the reference current profile 200 described above with reference to FIG. 2, if it is designed so that a relatively small reference current value tends to be associated with a relatively high SOC section, the reference current value that causes an excessive temperature rise is early switched to another lower reference current value, so that the charging procedure using the multi-stage constant-current charging protocol can be safely continued.

Additionally, the control unit 130 may also correct the reference charging map to correspond to the correction (adjusting the size of a specific SOC section) of any one of the plurality of reference charging maps (CM₁ to CM_{N}). For example, when a specific SOC section of the reference charging map is adjusted, the specific SOC section of the reference charging map may also be adjusted in the same way.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

In step S1062, the control unit 130 determines the predicted temperature change amount for the period until the SOC of the battery 11 reaches the start point of the (k+1)^{th} SOC section (Z[k+1]) from the start point of the k^{th} SOC section (Z[k]). At least one of the above-described first thermal model and second thermal model may be used to determine the predicted temperature change amount in the SOC section (Z[k]).

In step S1064, the control unit 130 determines the predicted temperature value at the start point of the (k+1)^{th} SOC section (Z[k+1]) to be equal to the sum of the predicted temperature change amount determined in step S1062 and the predicted temperature value at the start point of the k^{th} SOC section (Z[k]).

In step S1070, the control unit 130 increases the section index k by 1 and then returns to step S1030. That is, steps S1030 to S1070 can be repeated until k reaches M.

In step S1080, the control unit 130 determines the total remaining charging time until the charging procedure using the multi-stage constant-current charging protocol is terminated (i.e., until the SOC of the battery reaches the target SOC) by adding the m^{th} to M^{th} predicted charging time values. The m^{th} to M^{th} predicted charging time values correspond one-to-one to the m^{th} to M^{th} SOC sections (Z[m] to Z[M]).

FIG. 11 is a flowchart exemplarily illustrating a battery charging time prediction method according to the third embodiment of the present disclosure. The method of FIG. 11 can be executed to adjust the corresponding SOC section, provided that constant-current charging for at least one SOC section for which the predicted charging time value has been determined by any one of the first and second embodiments described above with reference to FIGS. 6 to 10 is actually completed. In explaining FIG. 11, it will be assumed that j is a natural number greater than or equal to m and less than or equal to M.

Referring to FIGS. 1 to 11, in step S1110, the control unit 130 determines the actual temperature change amount in the j^{th} SOC section (Z[j]). If the j^{th} SOC section (Z[j]) is the SOC section (e.g., Z[m]) at the charging start point using the multi-stage constant-current charging protocol, the difference between the battery temperature detection value at the charging start point and the battery temperature detection value at the end point of the SOC section (Z[m]) may be determined as the actual temperature change amount in the SOC section (Z[m]). Or, if the j^{th} SOC section (Z[j]) is a SOC section (e.g., Z[M]) different from the SOC section (e.g., Z[m]) at the charging start point, the difference between two battery temperature detection values at the start point and the end point of the SOC section (Z[M]) may be determined as the actual temperature change amount in the SOC section (Z[M]).

In step S1120, the control unit 130 determines whether the actual temperature change amount in the j^{th} SOC section (Z[j]) is greater than the predicted temperature change amount in the j^{th} SOC section (Z[j]).

Alternatively, the control unit 130 may correct the predicted temperature change amount in the j^{th} SOC section (Z[j]) based on the two outdoor air temperature detection values at the start point and the end point of the j^{th} SOC section (Z[j]), and then compare the corrected predicted temperature change amount with the actual temperature change amount in the j^{th} SOC section (Z[j]). Specifically, when determining the predicted temperature change amount in the j^{th} SOC section (Z[j]), T_{ATM} in Equation 3 may represent the outdoor air temperature at the start point of the j^{th} SOC section (Z[j]). Since the outdoor air temperature may change in the j^{th} SOC section (Z[j]), the predicted temperature change amount in the j^{th} SOC section (Z[j]) can be corrected by calculating the temperature correction value using Equation 5 below and then adding the temperature correction value to the predicted temperature change amount in the j^{th} SOC section (Z[j]). <Equation 5> $Δ {T}_{correct} = \frac{\frac{\left({T}_{ATM _ 2}-{T}_{ATM _ 1}\right)}{β}}{{C}_{H}} \times Δ t$

In Equation 5, T_{ATM_1} may be the outdoor air temperature detection value at the start point of the j^{th} SOC section (Z[j]), and T_{ATM_2} may be the outdoor air temperature detection value at the end point of the j^{th} SOC section (Z[j]). The values of other parameters are common to Equation 4. According to Equation 5, if T_{ATM_2} > T_{ATM_1}, ΔT_{correct} is positive, and the predicted temperature change amount in the j^{th} SOC section (Z[j]) increases through correction. Conversely, if T_{ATM_2} < T_{ATM_1}, ΔT_{correct} is negative, and the predicted temperature change amount in the j^{th} SOC section (Z[j]) decreases through correction.

If the value of step S1120 is "Yes," the process proceeds to step S1130.

In step S1130, the control unit 130 adjusts the j^{th} SOC section (Z[j]) according to the difference between the actual temperature change amount and the predicted temperature change amount in the j^{th} SOC section (Z[j]).

As an example, the control unit 130 may decrease the end point of the j^{th} SOC section (Z[j]) by an adjustment value that has a predetermined positive correlation with respect to the difference. Accordingly, the size of the j^{th} SOC section (Z[j]) is reduced by the adjustment value. In addition, the fact that the end point of the j^{th} SOC section (Z[j]) is advanced by the adjustment value means that the start point of the (j+1)^{th} SOC section (Z[j+1]) is also advanced by the adjustment value. Therefore, the size of the (j+1)^{th} SOC section (Z[j+1]) is increased by the adjustment value.

According to the third embodiment described above with reference to FIG. 11, when the multi-stage constant-current charging protocol is carried out in the future, the charging procedure for the SOC section with a history of temperature rise exceeding expectations is terminated early, and the charging procedure for the SOC section following the corresponding SOC section is started early. As can be seen from the reference current profile 200 described above with reference to FIG. 2, if it is designed so that a relatively small reference current value tends to be associated with a relatively high SOC section, the reference current value that causes an excessive temperature rise is early switched to another lower reference current value, so that the charging procedure using the multi-stage constant-current charging protocol can be safely continued.

Additionally, the control unit 130 may also correct the reference charging map to correspond to the correction (adjusting the size of a specific SOC section) of any one of the plurality of reference charging maps (CM₁ to CM_{N}). For example, when a specific SOC section of the reference charging map is adjusted, the specific SOC section of the reference charging map may also be adjusted in the same way.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

## Claims

1. A battery management system, comprising:
a memory (140) configured to store a plurality of reference charging maps (CM1, ..., CMN) associated with a plurality of temperature sections, wherein each reference charging map (CM1, ..., CMN) including first to M^{th} reference current values and first to M^{th} reference power curves associated with first to M^{th} SOC sections, and M is a natural number greater than or equal to 2;
a sensing unit (111, 113, 115) configured to detect voltage, current, and temperature of a battery (11); and
a control unit (130) configured to determine an estimated SOC value of the battery (11) based on the voltage detection value and the current detection value of the battery (11),
wherein the control unit (130) is configured to:
obtain a m^{th} reference power curve and a m^{th} reference current value associated with a m^{th} SOC section to which the estimated SOC value belongs, from the reference charging map (CM1, ..., CMN) associated with the temperature section to which the temperature detection value of the battery belongs, wherein m is a natural number less than or equal to M, and
determine a m^{th} predicted charging time value, which represents a time required for an SOC of the battery (11) to reach an end point of the m^{th} SOC section, according to the result of comparing a maximum output power of a charger (3) that supplies charging power to the battery and the m^{th} reference power curve, based on the difference between the end point of the m^{th} SOC section and the estimated SOC value, and at least one of the m^{th} reference current value, the maximum output power and the m^{th} reference power curve;
**characterized in that** the control unit (130) is configured to, in response to that the maximum output power of the charger (3) is between a minimum power value and a maximum power value of the m^{th} reference power curve:
determine an intersection SOC, which represents SOC at an intersection point (X) of the m^{th} reference power curve and the maximum output power, and
determine the m^{th} predicted charging time value based on the estimated SOC value, the intersection SOC, the end point of the m^{th} SOC section, the mth reference current value, the maximum output power, and the m^{th} reference power curve.

2. The battery management system according to claim 1, wherein the control unit (130) is configured to determine an expected time required when performing a constant-current charging mode using the m^{th} reference current value until the SOC of the battery (11) reaches the end point of the m^{th} SOC section from the estimated SOC value as the m^{th} predicted charging time value, in response to that the maximum output power of the charger (3) is greater than or equal to a maximum power value of the m^{th} reference power curve.

3. The battery management system according to claim 1, wherein the control unit (130) is configured to determine an expected time required when performing a constant-power charging mode using the maximum output power until the SOC of the battery (11) reaches the end point of the m^{th} SOC section from the estimated SOC value as the m^{th} predicted charging time value, in response to that the maximum output power of the charger (3) is less than or equal to a minimum power value of the m^{th} reference power curve.

4. The battery management system according to claim 1, wherein the control unit (130) is configured to:
determine a m^{th} predicted constant-current charging time value, which represents an expected time required when performing a constant-current charging mode using the m^{th} reference current value until the SOC of the battery (11) reaches the intersection SOC from the estimated SOC value,
determine a m^{th} predicted constant-power charging time value, which represents an expected time required when performing a constant-power charging mode using the maximum output power until the SOC of the battery reaches the end point of the m^{th} SOC section from the intersection SOC, and
determine the m^{th} predicted charging time value to be equal to the sum of the m^{th} predicted constant-current charging time value and the m^{th} predicted constant-power charging time value.

5. The battery management system according to claim 1, wherein the control unit (130) is configured to further determine a predicted temperature value at a start point of a (m+1)^{th} SOC section, when at least one SOC section subsequent to the m^{th} SOC section exists among the first to M^{th} SOC sections.

6. The battery management system according to claim 5, wherein the control unit (130) is configured to:
determine a predicted temperature change amount until the SOC of the battery (11) reaches the start point of the (m+1)^{th} SOC section from the estimated SOC value, based on the m^{th} reference current value and the m^{th} predicted charging time value, and
determine the predicted temperature value at the start point of the (m+1)^{th} SOC section by adding the predicted temperature change amount from the estimated SOC value to the end point of the m^{th} SOC section to the temperature detection value.

7. The battery management system according to claim 5, wherein the control unit (130) is configured to, for k being a natural number greater than or equal to (m+1) and less than or equal to M, in response to completing the determination of the predicted temperature value at a start point of a k^{th} SOC section:
obtain a k^{th} reference power curve and a k^{th} reference current value associated with the k^{th} SOC section from the reference charging map (CM1, ..., CMN) associated with the temperature section to which the predicted temperature value at the start point of the k^{th} SOC section belongs, and
determine a k^{th} predicted charging time value, which represents a time required for an SOC of the battery (11) to reach the end point from the start point of the k^{th} SOC section, according to the result of comparing the maximum output power of the charger (3) and the k^{th} reference power curve, based on a size of the k^{th} SOC section, and at least one of the k^{th} reference current value, the maximum output power, and the k^{th} reference power curve.

8. The battery management system according to claim 7, wherein the control unit (130) is configured to, in response to completing the determination of the predicted charging time value in the M^{th} SOC section, determine a total remaining time until the SOC of the battery reaches the end point of the M^{th} SOC section from the estimated SOC value by adding the m^{th} to M^{th} predicted charging time values determined for the m^{th} to M^{th} SOC sections.

9. A battery pack, comprising the battery management system according to any one of claims 1 to 8.

10. An electric vehicle, comprising the battery pack according to claim 9.

11. A battery charging time prediction method, comprising
determining an estimated SOC value of a battery (11) based on a voltage detection value and a current detection value of the battery (11);
obtaining a m^{th} reference power curve and a m^{th} reference current value associated with a m^{th} SOC section to which the estimated SOC value belongs, from a reference charging map (CM1, ..., CMN) associated with a temperature section to which a temperature detection value of the battery (11) belongs, among a plurality of reference charging maps (CM1, ..., CMN) associated with a plurality of temperature sections, wherein each reference charging map (CM1, ..., CMN) including first to M^{th} reference current values and first to M^{th} reference power curves associated with first to M^{th} SOC sections, M is a natural number greater than or equal to 2, and m is a natural number less than or equal to M; and
determining a m^{th} predicted charging time value, which represents a time required for an SOC of the battery to reach an end point of the m^{th} SOC section, according to the result of comparing a maximum output power of a charger (3) that supplies charging power to the battery (11) and the m^{th} reference power curve, based on the difference between the end point of the m^{th} SOC section and the estimated SOC value, and at least one of the m^{th} reference current value, the maximum output power and the m^{th} reference power curve;
**characterized in that**, in response to that the maximum output power of the charger (3) is between a minimum power value and a maximum power value of the m^{th} reference power curve:
determining an intersection SOC, which represents SOC at an intersection point (X) of the m^{th} reference power curve and the maximum output power, and
determining the m^{th} predicted charging time value based on the estimated SOC value, the intersection SOC, the end point of the m^{th} SOC section, the m^{th} reference current value, the maximum output power, and the m^{th} reference power curve.

12. The battery charging time prediction method according to claim 11, wherein the step of determining the m^{th} predicted charging time value is determining an expected time required when performing a constant-current charging mode using the m^{th} reference current value until the SOC of the battery reaches the end point of the m^{th} SOC section from the estimated SOC value as the m^{th} predicted charging time value, in response to that the maximum output power of the charger (3) is greater than or equal to a maximum power value of the m^{th} reference power curve.

13. The battery charging time prediction method according to claim 11, wherein the step of determining the m^{th} predicted charging time value is determining an expected time required when performing a constant-power charging mode using the maximum output power until the SOC of the battery reaches the end point of the m^{th} SOC section from the estimated SOC value as the m^{th} predicted charging time value, in response to that the maximum output power of the charger (3) is less than or equal to a minimum power value of the m^{th} reference power curve.

14. The battery charging time prediction method according to claim 11, wherein the step of determining the m^{th} predicted charging time value includes:
determining a m^{th} predicted constant-current charging time value, which represents an expected time required when performing a constant-current charging mode using the m^{th} reference current value until the SOC of the battery (11) reaches the intersection SOC from the estimated SOC value;
determining a m^{th} predicted constant-power charging time value, which represents an expected time required when performing a constant-power charging mode using the maximum output power until the SOC of the battery (11) reaches the end point of the m^{th} SOC section from the intersection SOC; and
determining the m^{th} predicted charging time value to be equal to the sum of the m^{th} predicted constant-current charging time value and the m^{th} predicted constant-power charging time value.

## Patentansprüche

1. Batterieverwaltungssystem, umfassend:
• einen Speicher (140), der so konfiguriert ist, dass er eine Vielzahl von Referenzladekarten (CM₁, ..., CM_{N}) speichert, die einer Vielzahl von Temperaturabschnitten zugeordnet sind, wobei jede Referenzladekarte (CM₁, ..., CM_{N}) erste bis M^{te} Referenzstromwerte und erste bis M^{te} Referenzleistungskurven enthält, die ersten bis M^{ten} SOC-Abschnitten zugeordnet sind, und M eine natürliche Zahl größer als oder gleich 2 ist;
• eine Erfassungseinheit (111, 113, 115), die so konfiguriert ist, dass sie eine Spannung, einen Strom und eine Temperatur einer Batterie (11) erfasst; und
• eine Steuereinheit (130), die so konfiguriert ist, dass sie einen geschätzten SOC-Wert der Batterie (11) basierend auf dem Spannungserfassungswert und dem Stromerfassungswert der Batterie (11) bestimmt,
wobei die Steuereinheit (130) konfiguriert ist zum:
• Erhalten einer m^{ten} Referenzleistungskurve und eines m^{ten} Referenzstromwerts, die einem m^{ten} SOC-Abschnitt zugeordnet sind, zu dem der geschätzte SOC-Wert gehört, aus der Referenzladekarte (CM₁, ..., CM_{N}), die dem Temperaturabschnitt zugeordnet ist, zu dem der Temperaturerfassungswert der Batterie gehört, wobei m eine natürliche Zahl kleiner als oder gleich M ist, und
• Bestimmen eines m^{ten} vorhergesagten Ladezeitwerts, der eine Zeit darstellt, die erforderlich ist, damit ein SOC der Batterie (11) einen Endpunkt des m^{ten} SOC-Abschnitts erreicht, gemäß dem Ergebnis des Vergleichens einer maximalen Ausgangsleistung eines Ladegeräts (3), das der Batterie Ladeleistung zuführt, und der m^{ten} Referenzleistungskurve, basierend auf der Differenz zwischen dem Endpunkt des m^{ten} SOC-Abschnitts und dem geschätzten SOC-Wert und mindestens einem von dem m^{ten} Referenzstromwert, der maximalen Ausgangsleistung und der m^{ten} Referenzleistungskurve;
**dadurch gekennzeichnet, dass** die Steuereinheit (130) konfiguriert ist, dass sie als Reaktion darauf, dass die maximale Ausgangsleistung des Ladegeräts (3) zwischen einem minimalen Leistungswert und einem maximalen Leistungswert der m^{ten} Referenzleistungskurve liegt, zum:
• Bestimmen eines Schnittpunkt-SOC, der einen SOC an einem Schnittpunkt (X) der m^{ten} Referenzleistungskurve und der maximalen Ausgangsleistung darstellt, und
• Bestimmen des m^{ten} vorhergesagten Ladezeitwerts basierend auf dem geschätzten SOC-Wert, dem Schnittpunkt-SOC, dem Endpunkt des m^{ten} SOC-Abschnitts, dem m^{ten} Referenzstromwert, der maximalen Ausgangsleistung und der m^{ten} Referenzleistungskurve.

2. Batterieverwaltungssystem nach Anspruch 1, wobei die Steuereinheit (130) so konfiguriert ist, dass sie als den m^{ten} vorhergesagten Ladezeitwert eine erwartete Zeit bestimmt, die erforderlich ist, wenn ein Konstantstrom-Lademodus unter Verwendung des m^{ten} Referenzstromwerts durchgeführt wird, bis der SOC der Batterie (11) den Endpunkt des m^{ten} SOC-Abschnitts ausgehend von dem geschätzten SOC-Wert erreicht, als Reaktion darauf, dass die maximale Ausgangsleistung des Ladegeräts (3) größer als oder gleich einem maximalen Leistungswert der m^{ten} Referenzleistungskurve ist.

3. Batterieverwaltungssystem nach Anspruch 1, wobei die Steuereinheit (130) so konfiguriert ist, dass sie als den m^{ten} vorhergesagten Ladezeitwert eine erwartete Zeit bestimmt, die erforderlich ist, wenn ein Konstantleistung-Lademodus unter Verwendung der maximalen Ausgangsleistung durchgeführt wird, bis der SOC der Batterie (11) den Endpunkt des m^{ten} SOC-Abschnitts ausgehend von dem geschätzten SOC-Wert erreicht, als Reaktion darauf, dass die maximale Ausgangsleistung des Ladegeräts (3) kleiner als oder gleich einem minimalen Leistungswert der m^{ten} Referenzleistungskurve ist.

4. Batterieverwaltungssystem nach Anspruch 1, wobei die Steuereinheit (130) konfiguriert ist zum:
• Bestimmen eines m^{ten} vorhergesagten Konstantstrom-Ladezeitwerts, der eine erwartete Zeit darstellt, die erforderlich ist, wenn ein Konstantstrom-Lademodus unter Verwendung des m^{ten} Referenzstromwerts durchgeführt wird, bis der SOC der Batterie (11) den Schnittpunkt-SOC ausgehend von dem geschätzten SOC-Wert erreicht,
• Bestimmen eines m^{ten} vorhergesagten Konstantleistung-Ladezeitwerts, der eine erwartete Zeit darstellt, die erforderlich ist, wenn ein Konstantleistung-Lademodus unter Verwendung der maximalen Ausgangsleistung durchgeführt wird, bis der SOC der Batterie den Endpunkt des m^{ten} SOC-Abschnitts ausgehend von dem Schnittpunkt-SOC erreicht, und
• Bestimmen des m^{ten} vorhergesagten Ladezeitwerts, sodass er gleich der Summe aus dem m^{ten} vorhergesagten Konstantstrom-Ladezeitwert und dem m^{ten} vorhergesagten Konstantleistung-Ladezeitwert ist.

5. Batterieverwaltungssystem nach Anspruch 1, wobei die Steuereinheit (130) so konfiguriert ist, dass sie ferner einen vorhergesagten Temperaturwert an einem Startpunkt eines (m+1)^{ten} SOC-Abschnitts bestimmt, wenn mindestens ein dem m^{ten} SOC-Abschnitt nachfolgender SOC-Abschnitt unter den ersten bis M^{ten} SOC-Abschnitten existiert.

6. Batterieverwaltungssystem nach Anspruch 5, wobei die Steuereinheit (130) konfiguriert ist zum:
• Bestimmen einer vorhergesagten Temperaturänderungsmenge, bis der SOC der Batterie (11) den Startpunkt des (m+1)^{ten} SOC-Abschnitts ausgehend von dem geschätzten SOC-Wert erreicht, basierend auf dem m^{ten} Referenzstromwert und dem m^{ten} vorhergesagten Ladezeitwert, und
• Bestimmen des vorhergesagten Temperaturwerts an dem Startpunkt des (m+1)^{ten} SOC-Abschnitts durch Addieren der vorhergesagten Temperaturänderungsmenge ausgehend von dem geschätzten SOC-Wert bis zu dem Endpunkt des m^{ten} SOC-Abschnitts zu dem Temperaturerfassungswert.

7. Batterieverwaltungssystem nach Anspruch 5, wobei die Steuereinheit (130) konfiguriert ist, sodass sie, für k als eine natürliche Zahl größer als oder gleich (m+1) und kleiner als oder gleich M, als Reaktion auf das Abschließen der Bestimmung des vorhergesagten Temperaturwerts an einem Startpunkt eines k^{ten} SOC-Abschnitts, zum:
• Erhalten einer k^{ten} Referenzleistungskurve und eines k^{ten} Referenzstromwerts, die dem k^{ten} SOC-Abschnitt zugeordnet sind, aus der Referenzladekarte (CM₁, ..., CM_{N}), die dem Temperaturabschnitt zugeordnet ist, zu dem der vorhergesagte Temperaturwert an dem Startpunkt des k^{ten} SOC-Abschnitts gehört, und
• Bestimmen eines k^{ten} vorhergesagten Ladezeitwerts, der eine Zeit darstellt, die erforderlich ist, damit ein SOC der Batterie (11) den Endpunkt ausgehend von dem Startpunkt des k^{ten} SOC-Abschnitts erreicht, gemäß dem Ergebnis des Vergleichens der maximalen Ausgangsleistung des Ladegeräts (3) und der k^{ten} Referenzleistungskurve, basierend auf einer Größe des k^{ten} SOC-Abschnitts und mindestens einem von dem k^{ten} Referenzstromwert, der maximalen Ausgangsleistung und der k^{ten} Referenzleistungskurve.

8. Batterieverwaltungssystem nach Anspruch 7, wobei die Steuereinheit (130) so konfiguriert ist, dass sie als Reaktion auf das Abschließen der Bestimmung des vorhergesagten Ladezeitwerts in dem M^{ten} SOC-Abschnitt eine verbleibende Gesamtzeit, bis der SOC der Batterie den Endpunkt des M^{ten} SOC-Abschnitts ausgehend von dem geschätzten SOC-Wert erreicht, durch Addieren der m^{ten} bis M^{ten} vorhergesagten Ladezeitwerte bestimmt, die für die m^{ten} bis M^{ten} SOC-Abschnitte bestimmt wurden.

9. Batteriepack, umfassend das Batterieverwaltungssystem nach einem der Ansprüche 1 bis 8.

10. Elektrofahrzeug, umfassend das Batteriepack nach Anspruch 9.

11. Batterieladezeitvorhersageverfahren, umfassend:
• Bestimmen eines geschätzten SOC-Werts einer Batterie (11) basierend auf einem Spannungserfassungswert und einem Stromerfassungswert der Batterie (11);
• Erhalten einer m^{ten} Referenzleistungskurve und eines m^{ten} Referenzstromwerts, die einem m^{ten} SOC-Abschnitt zugeordnet sind, zu dem der geschätzte SOC-Wert gehört, aus einer Referenzladekarte (CM₁, ..., CM_{N}), die einem Temperaturabschnitt zugeordnet ist, zu dem ein Temperaturerfassungswert der Batterie (11) gehört, aus einer Vielzahl von Referenzladekarten (CM₁, ..., CM_{N}), die einer Vielzahl von Temperaturabschnitten zugeordnet sind, wobei jede Referenzladekarte (CM₁, ..., CM_{N}) erste bis M^{te} Referenzstromwerte und erste bis M^{te} Referenzleistungskurven enthält, die ersten bis M^{ten} SOC-Abschnitten zugeordnet sind, M eine natürliche Zahl größer als oder gleich 2 ist und m eine natürliche Zahl kleiner als oder gleich M ist; und
• Bestimmen eines m^{ten} vorhergesagten Ladezeitwerts, der eine Zeit darstellt, die erforderlich ist, damit ein SOC der Batterie den Endpunkt des m^{ten} SOC-Abschnitts erreicht, gemäß dem Ergebnis des Vergleichens einer maximalen Ausgangsleistung eines Ladegeräts (3), das der Batterie (11) Ladeleistung zuführt, und der m^{ten} Referenzleistungskurve, basierend auf der Differenz zwischen dem Endpunkt des m^{ten} SOC-Abschnitts und dem geschätzten SOC-Wert und mindestens einem von dem m^{ten} Referenzstromwert, der maximalen Ausgangsleistung und der m^{ten} Referenzleistungskurve;
**dadurch gekennzeichnet, dass**, als Reaktion darauf, dass die maximale Ausgangsleistung des Ladegeräts (3) zwischen einem minimalen Leistungswert und einem maximalen Leistungswert der m^{ten} Referenzleistungskurve liegt:
• Bestimmen eines Schnittpunkt-SOC, der einen SOC an einem Schnittpunkt (X) der m^{ten} Referenzleistungskurve und der maximalen Ausgangsleistung darstellt, und
• Bestimmen des m^{ten} vorhergesagten Ladezeitwerts basierend auf dem geschätzten SOC-Wert, dem Schnittpunkt-SOC, dem Endpunkt des m^{ten} SOC-Abschnitts, dem m^{ten} Referenzstromwert, der maximalen Ausgangsleistung und der m^{ten} Referenzleistungskurve.

12. Batterieladezeitvorhersageverfahren nach Anspruch 11, wobei der Schritt des Bestimmens des m^{ten} vorhergesagten Ladezeitwerts das Bestimmen einer erwarteten Zeit, die erforderlich ist, wenn ein Konstantstrom-Lademodus unter Verwendung des m^{ten} Referenzstromwerts durchgeführt wird, bis der SOC der Batterie den Endpunkt des m^{ten} SOC-Abschnitts ausgehend von dem geschätzten SOC-Wert erreicht, als den m^{ten} vorhergesagten Ladezeitwert als Reaktion darauf ist, dass die maximale Ausgangsleistung des Ladegeräts (3) größer als oder gleich einem maximalen Leistungswert der m^{ten} Referenzleistungskurve ist.

13. Batterieladezeitvorhersageverfahren nach Anspruch 11, wobei der Schritt des Bestimmens des m^{ten} vorhergesagten Ladezeitwerts das Bestimmen einer erwarteten Zeit, die erforderlich ist, wenn ein Konstantleistung-Lademodus unter Verwendung der maximalen Ausgangsleistung durchgeführt wird, bis der SOC der Batterie den Endpunkt des m^{ten} SOC-Abschnitts ausgehend von dem geschätzten SOC-Wert erreicht, als den m^{ten} vorhergesagten Ladezeitwert als Reaktion darauf ist, dass die maximale Ausgangsleistung des Ladegeräts (3) kleiner als oder gleich einem minimalen Leistungswert der m^{ten} Referenzleistungskurve ist.

14. Batterieladezeitvorhersageverfahren nach Anspruch 11, wobei der Schritt des Bestimmens des m^{ten} vorhergesagten Ladezeitwerts enthält:
• Bestimmen eines m^{ten} vorhergesagten Konstantstrom-Ladezeitwerts, der eine erwartete Zeit darstellt, die erforderlich ist, wenn ein Konstantstrom-Lademodus unter Verwendung des m^{ten} Referenzstromwerts durchgeführt wird, bis der SOC der Batterie (11) den Schnittpunkt-SOC ausgehend von dem geschätzten SOC-Wert erreicht;
• Bestimmen eines m^{ten} vorhergesagten Konstantleistung-Ladezeitwerts, der eine erwartete Zeit darstellt, die erforderlich ist, wenn ein Konstantleistung-Lademodus unter Verwendung der maximalen Ausgangsleistung durchgeführt wird, bis der SOC der Batterie (11) den Endpunkt des m^{ten} SOC-Abschnitts ausgehend von dem Schnittpunkt-SOC erreicht; und
• Bestimmen des m^{ten} vorhergesagten Ladezeitwerts so, dass er gleich der Summe aus dem m^{ten} vorhergesagten Konstantstrom-Ladezeitwert und dem m^{ten} vorhergesagten Konstantleistung-Ladezeitwert ist.

## Revendications

1. Un système de gestion de batterie, comprenant :
une mémoire (140) configurée pour stocker une pluralité de cartes de charge de référence (CM₁, ..., CM_{N}) associées à une pluralité de sections de température, dans lequel chaque carte de charge de référence (CM₁, ..., CM_{N}) comprend des première à M^{ième} valeurs de courant de référence et des première à M^{ième} courbes de puissance de référence associées à des première à M^{ième} sections de SOC, et M est un nombre entier naturel supérieur ou égal à 2 ;
une unité de détection (111, 113, 115) configurée pour détecter la tension, le courant et la température d'une batterie (11) ; et
une unité de commande (130) configurée pour déterminer une valeur de SOC estimée de la batterie (11) sur la base de la valeur de détection de tension et de la valeur de détection de courant de la batterie (11),
dans lequel l'unité de commande (130) est configurée pour :
obtenir une m^{ième} courbe de puissance de référence et une m^{ième} valeur de courant de référence associées à une m^{ième} section de SOC à laquelle appartient la valeur de SOC estimée, à partir de la carte de charge de référence (CM₁, ..., CM_{N}) associée à la section de température à laquelle appartient la valeur de détection de température de la batterie, dans lequel m est un nombre entier naturel inférieur ou égal à M, et
déterminer une m^{ième} valeur de temps de charge prédite, qui représente un temps requis pour qu'un SOC de la batterie (11) atteigne un point final de la m^{ième} section de SOC, selon le résultat de la comparaison d'une puissance de sortie maximale d'un chargeur (3) qui fournit une puissance de charge à la batterie et de la m^{ième} courbe de puissance de référence, sur la base de la différence entre le point final de la m^{ième} section de SOC et la valeur de SOC estimée, et d'au moins une parmi la m^{ième} valeur de courant de référence, la puissance de sortie maximale et la m^{ième} courbe de puissance de référence ;
**caractérisé en ce que** l'unité de commande (130) est configurée pour, en réponse au fait que la puissance de sortie maximale du chargeur (3) est comprise entre une valeur de puissance minimale et une valeur de puissance maximale de la m^{ième} courbe de puissance de référence :
déterminer un SOC d'intersection, qui représente le SOC à un point d'intersection (X) de la m^{ième} courbe de puissance de référence et de la puissance de sortie maximale, et
déterminer la m^{ième} valeur de temps de charge prédite sur la base de la valeur de SOC estimée, du SOC d'intersection, du point final de la m^{ième} section de SOC, de la m^{ième} valeur de courant de référence, de la puissance de sortie maximale, et de la m^{ième} courbe de puissance de référence.

2. Le système de gestion de batterie selon la revendication 1, dans lequel l'unité de commande (130) est configurée pour déterminer un temps attendu requis lors de la réalisation d'un mode de charge à courant constant en utilisant la m^{ième} valeur de courant de référence jusqu'à ce que le SOC de la batterie (11) atteigne le point final de la m^{ième} section de SOC à partir de la valeur de SOC estimée comme étant la m^{ième} valeur de temps de charge prédite, en réponse au fait que la puissance de sortie maximale du chargeur (3) est supérieure ou égale à une valeur de puissance maximale de la m^{ième} courbe de puissance de référence.

3. Le système de gestion de batterie selon la revendication 1, dans lequel l'unité de commande (130) est configurée pour déterminer un temps attendu requis lors de la réalisation d'un mode de charge à puissance constante en utilisant la puissance de sortie maximale jusqu'à ce que le SOC de la batterie (11) atteigne le point final de la m^{ième} section de SOC à partir de la valeur de SOC estimée comme étant la m^{ième} valeur de temps de charge prédite, en réponse au fait que la puissance de sortie maximale du chargeur (3) est inférieure ou égale à une valeur de puissance minimale de la m^{ième} courbe de puissance de référence.

4. Le système de gestion de batterie selon la revendication 1, dans lequel l'unité de commande (130) est configurée pour :
déterminer une m^{ième} valeur de temps de charge à courant constant prédite, qui représente un temps attendu requis lors de la réalisation d'un mode de charge à courant constant en utilisant la m^{ième} valeur de courant de référence jusqu'à ce que le SOC de la batterie (11) atteigne le SOC d'intersection à partir de la valeur de SOC estimée,
déterminer une m^{ième} valeur de temps de charge à puissance constante prédite, qui représente un temps attendu requis lors de la réalisation d'un mode de charge à puissance constante en utilisant la puissance de sortie maximale jusqu'à ce que le SOC de la batterie atteigne le point final de la m^{ième} section de SOC à partir du SOC d'intersection, et
déterminer la m^{ième} valeur de temps de charge prédite comme étant égale à la somme de la m^{ième} valeur de temps de charge à courant constant prédite et de la m^{ième} valeur de temps de charge à puissance constante prédite.

5. Le système de gestion de batterie selon la revendication 1, dans lequel l'unité de commande (130) est configurée pour déterminer en outre une valeur de température prédite au niveau d'un point de départ d'une (m+1)^{ième} section de SOC, lorsqu'il existe au moins une section de SOC postérieure à la m^{ième} section de SOC parmi les première à M^{ième} sections de SOC.

6. Le système de gestion de batterie selon la revendication 5, dans lequel l'unité de commande (130) est configurée pour :
déterminer une quantité de changement de température prédite jusqu'à ce que le SOC de la batterie (11) atteigne le point de départ de la (m+1)^{ième} section de SOC à partir de la valeur de SOC estimée, sur la base de la m^{ième} valeur de courant de référence et de la m^{ième} valeur de temps de charge prédite, et
déterminer la valeur de température prédite au niveau du point de départ de la (m+1)^{ième} section de SOC en ajoutant la quantité de changement de température prédite entre la valeur de SOC estimée et le point final de la m^{ième} section de SOC à la valeur de détection de température.

7. Le système de gestion de batterie selon la revendication 5, dans lequel l'unité de commande (130) est configurée pour, pour k étant un nombre entier naturel supérieur ou égal à (m+1) et inférieur ou égal à M, en réponse à l'achèvement de la détermination de la valeur de température prédite au niveau d'un point de départ d'une k^{ième} section de SOC :
obtenir une k^{ième} courbe de puissance de référence et une k^{ième} valeur de courant de référence associées à la k^{ième} section de SOC à partir de la carte de charge de référence (CM₁, ..., CM_{N}) associée à la section de température à laquelle appartient la valeur de température prédite au niveau du point de départ de la k^{ième} section de SOC, et
déterminer une k^{ième} valeur de temps de charge prédite, qui représente un temps requis pour qu'un SOC de la batterie (11) atteigne le point final à partir du point de départ de la k^{ième} section de SOC, selon le résultat de la comparaison de la puissance de sortie maximale du chargeur (3) et de la k^{ième} courbe de puissance de référence, sur la base d'une taille de la k^{ième} section de SOC, et d'au moins une parmi la k^{ième} valeur de courant de référence, la puissance de sortie maximale et la k^{ième} courbe de puissance de référence.

8. Le système de gestion de batterie selon la revendication 7, dans lequel l'unité de commande (130) est configurée pour, en réponse à l'achèvement de la détermination de la valeur de temps de charge prédite dans la M^{ième} section de SOC, déterminer un temps restant total jusqu'à ce que le SOC de la batterie atteigne le point final de la M^{ième} section de SOC à partir de la valeur de SOC estimée en ajoutant les m^{ième} à M^{ième} valeurs de temps de charge prédites déterminées pour les m^{ième} à M^{ième} sections de SOC.

9. Un bloc-batterie, comprenant le système de gestion de batterie selon l'une quelconque des revendications 1 à 8.

10. Un véhicule électrique, comprenant le bloc-batterie selon la revendication 9.

11. Un procédé de prédiction de temps de charge de batterie, comprenant :
déterminer une valeur de SOC estimée d'une batterie (11) sur la base d'une valeur de détection de tension et d'une valeur de détection de courant de la batterie (11) ;
obtenir une m^{ième} courbe de puissance de référence et d'une m^{ième} valeur de courant de référence associées à une m^{ième} section de SOC à laquelle appartient la valeur de SOC estimée, à partir d'une carte de charge de référence (CM₁, ..., CM_{N}) associée à une section de température à laquelle appartient une valeur de détection de température de la batterie (11), parmi une pluralité de cartes de charge de référence (CM₁, ..., CM_{N}) associées à une pluralité de sections de température, dans lequel chaque carte de charge de référence (CM₁, ..., CM_{N}) comprend des première à M^{ième} valeurs de courant de référence et des première à M^{ième} courbes de puissance de référence associées à des première à M^{ième} sections de SOC, M est un nombre entier naturel supérieur ou égal à 2, et m est un nombre entier naturel inférieur ou égal à M ; et
déterminer une m^{ième} valeur de temps de charge prédite, qui représente un temps requis pour qu'un SOC de la batterie atteigne un point final de la m^{ième} section de SOC, selon le résultat de la comparaison d'une puissance de sortie maximale d'un chargeur (3) qui fournit une puissance de charge à la batterie (11) et de la m^{ième} courbe de puissance de référence, sur la base de la différence entre le point final de la m^{ième} section de SOC et la valeur de SOC estimée, et d'au moins une parmi la m^{ième} valeur de courant de référence, la puissance de sortie maximale et la m^{ième} courbe de puissance de référence ;
**caractérisé en ce que**, en réponse au fait que la puissance de sortie maximale du chargeur (3) est comprise entre une valeur de puissance minimale et une valeur de puissance maximale de la m^{ième} courbe de puissance de référence :
déterminer un SOC d'intersection, qui représente le SOC à un point d'intersection (X) de la m^{ième} courbe de puissance de référence et de la puissance de sortie maximale, et
déterminer la m^{ième} valeur de temps de charge prédite sur la base de la valeur de SOC estimée, du SOC d'intersection, du point final de la m^{ième} section de SOC, de la m^{ième} valeur de courant de référence, de la puissance de sortie maximale, et de la m^{ième} courbe de puissance de référence.

12. Le procédé de prédiction de temps de charge de batterie selon la revendication 11, dans lequel l'étape de détermination de la m^{ième} valeur de temps de charge prédite consiste à déterminer un temps attendu requis lors de la réalisation d'un mode de charge à courant constant en utilisant la m^{ième} valeur de courant de référence jusqu'à ce que le SOC de la batterie atteigne le point final de la m^{ième} section de SOC à partir de la valeur de SOC estimée comme étant la m^{ième} valeur de temps de charge prédite, en réponse au fait que la puissance de sortie maximale du chargeur (3) est supérieure ou égale à une valeur de puissance maximale de la m^{ième} courbe de puissance de référence.

13. Le procédé de prédiction de temps de charge de batterie selon la revendication 11, dans lequel l'étape de détermination de la m^{ième} valeur de temps de charge prédite consiste à déterminer un temps attendu requis lors de la réalisation d'un mode de charge à puissance constante en utilisant la puissance de sortie maximale jusqu'à ce que le SOC de la batterie atteigne le point final de la m^{ième} section de SOC à partir de la valeur de SOC estimée comme étant la m^{ième} valeur de temps de charge prédite, en réponse au fait que la puissance de sortie maximale du chargeur (3) est inférieure ou égale à une valeur de puissance minimale de la m^{ième} courbe de puissance de référence.

14. Le procédé de prédiction de temps de charge de batterie selon la revendication 11, dans lequel l'étape de détermination de la m^{ième} valeur de temps de charge prédite comprend :
déterminer une m^{ième} valeur de temps de charge à courant constant prédite, qui représente un temps attendu requis lors de la réalisation d'un mode de charge à courant constant en utilisant la m^{ième} valeur de courant de référence jusqu'à ce que le SOC de la batterie (11) atteigne le SOC d'intersection à partir de la valeur de SOC estimée ;
déterminer une m^{ième} valeur de temps de charge à puissance constante prédite, qui représente un temps attendu requis lors de la réalisation d'un mode de charge à puissance constante en utilisant la puissance de sortie maximale jusqu'à ce que le SOC de la batterie (11) atteigne le point final de la m^{ième} section de SOC à partir du SOC d'intersection ; et
déterminer la m^{ième} valeur de temps de charge prédite comme étant égale à la somme de la m^{ième} valeur de temps de charge à courant constant prédite et de la m^{ième} valeur de temps de charge à puissance constante prédite.
